# EUROPEAN PATENT APPLICATION

(11) **EP 4 317 240 A1**
(43) Date of publication of application: **07.02.2024**
(21) Application number: 22775276.3
(22) Date of filing: 15.03.2022
(51) Int. Cl.: C08G 59/68, C08G 69/00, C08G 73/06, G03F 7/004, G03F 7/037, H05K 3/28

(54) **NEGATIVE PHOTOSENSITIVE RESIN COMPOSITION, NEGATIVE PHOTOSENSITIVE RESIN COMPOSITION FILM, CURED PRODUCT, PREPARATION METHOD OF CURED PRODUCT, HOLLOW STRUCTURE, AND ELECTRONIC COMPONENT**

(30) Priority: 23.03.2021 JP 2021048312
(71) Applicant: Toray Industries, Inc., Tokyo 103-8666 (JP)
(72) Inventor: AOSHIMA, Kenta, Otsu-shi, Shiga 520-8558 (JP); KOYAMA, Yutaro, Otsu-shi, Shiga 520-8558 (JP); MATSUMURA, Kazuyuki, Otsu-shi, Shiga 520-8558 (JP); ARAKI, Hitoshi, Otsu-shi, Shiga 520-8558 (JP)
(74) Representative: Hoefer & Partner Patentanwälte mbB
(86) International application number: PCT/JP2022/011591
(87) International publication number: WO 2022/202486

(57) **Abstract**

It is intended to provide a negative type photosensitive resin composition that ensures high aspect ratio pattern processability, high storage stability, and high curability and also provides a cured product with good mechanical characteristics and high heat resistance. A negative type photosensitive resin composition comprising a polymer compound (A), a cationic polymerizable compound (B), a cationic polymerization initiator (C), and a solvent (D) wherein the component (A) contains at least one compound selected from the group consisting of polyamide, polyimide, polybenzoxazole, precursors thereof, and copolymers thereof and wherein both the relations 0.6A ≤ B + 0.5C ≤ 0.98A and 0.05(B + C) ≤ C ≤ 0.25(B + C) are satisfied where A (moles), B (moles), and C (moles) represent the quantities of all carboxylic acid residues, all diamine residues, and all monoamine residues, respectively, contained in the component (A).

## Description

### TECHNICAL FIELD

The present invention relates to a negative type photosensitive resin composition, a negative type photosensitive resin composition film, a cured product, a production method for a cured product, a hollow structure, and an electronic component. More particularly, it relates to a negative type photosensitive resin composition that can be suitably used to produce a surface protection film and an interlaminar insulation film for electronic components and a structure for MEMS (microelectromechanical systems).

### BACKGROUND ART

Conventionally, polyimide based materials and polybenzoxazole based materials, which generally have high heat resistance, good electrical insulation properties, and good mechanical characteristics, have been widely used for surface protection films and interlaminar insulation films of electronic components.

To meet the recent demand for higher performance in electronic components, fine patterning and high aspect ratio processing are now required in manufacturing surface protection films and interlaminar insulation films. Chemical amplification type cation curable photosensitive resins have been disclosed in order to meet such demand (for example, see Patent document 1). In addition, some documents have disclosed photo-cation curable photosensitive resins that contain epoxy resins of specific structures with the aim of improving mechanical characteristics and heat resistance (for example, see Patent document 2).

### PRIOR ART DOCUMENTS

### PATENT DOCUMENTS

Patent document 1: International Publication WO 2008/007764
Patent document 2: Japanese Unexamined Patent Publication (Kokai) No. 2019-38964

### SUMMARY OF INVENTION

### PROBLEMS TO BE SOLVED BY THE INVENTION

However, it is difficult for such photo-cation polymerized materials to develop both mechanical characteristics and thermal characteristics adequately. Specifically, if the crosslink density is increased with the aim of producing a cured film with a high glass transition temperature, which is an indicator of thermal characteristics, the resulting cured film tends to be low in tensile strength or tensile elongation, which are indicators of mechanical characteristics. On the other hand, if a flexible component is introduced in order to increase the tensile strength or tensile elongation, the resulting cured film tends to decrease in glass transition temperature. Furthermore, if a conventional polyimide resin or polybenzoxazole resin is added with the aim of improving both mechanical characteristics and thermal characteristics, the functional groups in side chains or terminals tend to impede or excessively enhance the cationic polymerization reaction, making it difficult to realize both high photo-curability and storage stability simultaneously.

### MEANS OF SOLVING THE PROBLEMS

The present invention, which is designed for solving the above problems, is as described below.

It provides a negative type photosensitive resin composition including a polymer compound (A), a cationic polymerizable compound (B), and a cationic polymerization initiator (C) wherein the component (A) contains at least one compound selected from the group consisting of polyamide, polyimide, polybenzoxazole, precursors thereof, and copolymers thereof and wherein both the relations 0.6A ≤ B + 0.5C ≤ 0.98A and 0.05(B + C) ≤ C ≤ 0.25(B + C) are satisfied where A (moles), B (moles), and C (moles) represent the quantities of all carboxylic acid residues, all diamine residues, and all monoamine residues, respectively, contained in the component (A).

### ADVANTAGEOUS EFFECTS OF THE INVENTION

The present invention provides a negative type photosensitive resin composition that ensures high aspect ratio pattern processability, high storage stability, and high photo-curability and also provides a cured product with good mechanical characteristics and high heat resistance.

### DESCRIPTION OF PREFERRED EMBODIMENTS

The negative type photosensitive resin composition according to the present invention includes a polymer compound (A), a cationic polymerizable compound (B), and a cationic polymerization initiator (C), with the component (A) containing at least one compound selected from the group consisting of polyamide, polyimide, polybenzoxazole, precursors thereof, and copolymers thereof, and the negative type photosensitive resin composition also satisfies both the relations 0.6A ≤ B + 0.5C ≤ 0.98A and 0.05(B + C) ≤ C ≤ 0.25(B + C) where A (moles), B (moles), and C (moles) represent the quantities of all carboxylic acid residues, all diamine residues, and all monoamine residues, respectively, contained in the component (A). Hereinafter, the requirement for the component (A) to contain at least one compound selected from the group consisting of polyamide, polyimide, polybenzoxazole, precursors thereof, and copolymers thereof will be occasionally referred to as the requirement (i). In addition, the relations 0.6A ≤ B + 0.5C ≤ 0.98A and 0.05(B + C) ≤ C ≤ 0.25(B + C) will be occasionally referred to as the requirement (ii-1) and the requirement (ii-2), respectively, and satisfying both the requirement (ii-1) and the requirement (ii-2) will be occasionally referred to as satisfying the requirement (ii).

First, the polymer compound (A) (hereinafter occasionally referred to as the component (A)) will be described.

For the present invention, a compound that contains at least one compound selected from the group consisting of polyamide, polyimide, polybenzoxazole, precursors thereof, and copolymers thereof is used as the component (A). Here, the term "polyamide" refers to a polyamide that is not a polyimide precursor or a polybenzoxazole precursor unless otherwise specified. In regard to the component (A) used for the present invention, it is preferable that the compound that contains at least one compound selected from the group consisting of polyamide, polyimide, polybenzoxazole, precursors thereof, and copolymers thereof account for 80% to 100% by mass, more preferably 90% to 100% by mass, still more preferably 95% to 100% by mass, and particularly preferably 98% to 100% by mass, in the component (A).

Examples of the polyamide include compounds formed by reacting a dicarboxylic acid and a diamine compound with a polyphosphoric acid to achieve dehydrative condensation.

Examples of the polyimide precursors include those formed by reacting a tetracarboxylic acid or a derivative thereof with a diamine or a derivative thereof, and such compounds include polyamide acid, polyamide acid ester, polyamide acid amide, and polyisoimide. Examples of the polyimide include compounds formed by subjecting the aforementioned polyamide acid, polyamide acid ester, polyamide acid amide, or polyisoimide to dehydration and cyclization by heating or through a reaction using an acid or base.

Examples of the polybenzoxazole precursors include poly-(o-hydroxyamide) that is formed by reacting a dicarboxylic acid, a derivative thereof, and a diamine such as o-bisaminophenol. Examples of the polybenzoxazole include compounds formed by subjecting the aforementioned poly-(o-hydroxyamide) to dehydration and cyclization by heating or through a reaction using an acid or base.

Examples of the copolymers include those of two polymer compounds such as copolymers of polyamide with polyimide or precursors thereof, copolymers of polyamide with polybenzoxazole or precursors thereof, copolymers of polybenzoxazole or precursors thereof with polyimide or precursors thereof, copolymers of polyimide with precursors thereof, and copolymers of polybenzoxazole with precursors thereof, and copolymers of three or more compounds may also be used.

A carboxylic acid residue contained in the component (A) is a residue derived from a carboxylic acid or a carboxylic acid derivative that can serve to form at least one compound selected from the group consisting of polyamide, polyimide, polybenzoxazole, precursors thereof, and copolymers thereof, and examples thereof include residue structures derived from monocarboxylic acids, dicarboxylic acids, tetracarboxylic acids, acid anhydrides, acid dianhydrides, monoacid chlorides, diacid chlorides, etc. Examples of carboxylic acids and carboxylic acid derivatives include, but not limited to, aromatic dicarboxylic acids, aromatic acid anhydrides, alicyclic dicarboxylic acids, and alicyclic acid dianhydrides. Here, these may be used singly or as a combination of two or more thereof.

A diamine residue contained in the component (A) is a residue derived from a diamine or a diamine derivative that can serve to form at least one compound selected from the group consisting of polyamide, polyimide, polybenzoxazole, precursors thereof, and copolymers thereof, and examples thereof include residue structures derived from diamines, diisocyanates, etc. Examples of diamine and derivatives thereof include, but not limited to, aromatic diamines, aromatic diisocyanates, alicyclic diamines, and alicyclic diisocyanates. Here, these may be used singly or as a combination of two or more thereof.

A monoamine residue contained in the component (A) is a residue derived from monoamine or a derivative thereof that can serve to form at least one compound selected from the group consisting of polyamide, polyimide, polybenzoxazole, precursors thereof, and copolymers thereof, and examples thereof include residue structures derived from monoamines, monoisocyanates, etc. Examples of monoamines and derivatives thereof include, but not limited to, aromatic monoamines, aromatic monoisocyanates, alicyclic monoamines, and alicyclic monoisocyanates. Here, these may be used singly or as a combination of two or more thereof.

From the viewpoint of heat resistance and chemical resistance of the resulting cured product, it is preferable for the monoamine residue in use to have a crosslinkable functional group. Examples of the crosslinkable functional group include, but not limited to, hydroxy group and ethynyl group. Of such a crosslinkable functional group as mentioned above, the hydroxy group is preferable from the viewpoint of solubility in alkali.

For the present invention, the compound used as the component (A) should satisfy the relation 0.6A ≤ B + 0.5C ≤ 0.98A where A (moles), B (moles), and C (moles) represent the total quantity of carboxylic acid residues, the total quantity of diamine residues, and the total quantity of monoamine residues, respectively, contained in the component (A). When the relation 0.6A ≤ B + 0.5C is satisfied, the weight average molecular weight of the polymer compound (A) tends to be 1,000 or more and makes it possible to form a cured product with good mechanical characteristics. When the relation B + 0.5C ≤ 0.98A is satisfied, it will be possible to reduce the proportion of molecular chains having diamine residues at terminals, which can work to deactivate cations. This facilitates the progress of photo-cation polymerization and ensures a high photo-curability. It is more preferable that the relation 0.8A ≤ B + 0.5C ≤ 0.98A be satisfied and still more preferable that the relation 0.9A ≤ B + 0.5C ≤ 0.98A be satisfied because it serves to achieve better mechanical characteristics and higher photo-curability as compared with the relation described above.

Furthermore, the compound used as the component (A) for the present invention should satisfy the relation 0.05(B + C) ≤ C ≤ 0.25(B + C). If the relation 0.05(B + C) ≤ C is satisfied, part of the molecular chain terminals in the component (A) are capped with monamine residues and this prevents an excessive reaction between the carboxylic acid residue in the component (A) and the component (B). Accordingly, the resulting negative type photosensitive resin composition is prevented from suffering an increase in viscosity when it is stored at room temperature. If the relation C ≤ 0.25(B + C) is satisfied, the weight average molecular weight of the component (A) tends to be 1,000 or more and makes it possible to form a cured product with good mechanical characteristics. It is more preferable that the relation 0.05(B + C) ≤ C ≤ 0.15(B + C) be satisfied and still more preferable that the relation 0.05(B + C) ≤ C ≤ 0.10(B + C) be satisfied because it serves to achieve higher storage stability and better mechanical characteristics.

For the present invention, the percent contents of carboxylic acid residues, diamine residues, and monamine residues contained in the component (A) can be determined by the following method. For example, the component (A) is dissolved in an acidic solution and analyzed by gas chromatography (GC) or nuclear magnetic resonance (NMR), which serves to detect the carboxylic acid residues, diamine residues, and monamine residues contained in the component (A) and determine their percent contents. Alternatively, the negative type photosensitive resin composition or the component (A) may be analyzed directly by NMR etc. This also serves to detect the carboxylic acid residues, diamine residues, and monamine residues contained in the component (A) and determine their percent contents. In the case where a negative type photosensitive resin composition is prepared using an unpurified polymerization solution of the component (A), the ratio among the carboxylic acid residues, diamine residues, and monamine residues contained in the component (A) should be equal to the monomer feed ratio adopted for the polymerization of the component (A). Therefore, they can be calculated from the monomer feed ratio used for the polymerization of the component (A).

For the present invention, it is preferable for the component (A) to account for 10 mass% or more and 90 mass% or less, more preferably 20 mass% or more and 80 mass% or less, and still more preferably 30 mass% or more and 70 mass% or less, relative to 100 mass% of the aforementioned negative type photosensitive resin composition. If the content is in this range, it serves to ensure high processability, good mechanical characteristics, and high heat resistance.

For the present invention, it is preferable for the component (A) to have a weight average molecular weight of 1,000 or more and 200,000 or less, more preferably 5,000 or more and 100,000 or less, and still more preferably 10,000 or more and 50,000 or less. If it is in this range, it serves to ensure high processability, good mechanical characteristics, and high heat resistance. The weight average molecular weight is measured by gel permeation chromatography (GPC) and converted in terms of polystyrene.

For the present invention, it is preferable for the component (A) to be soluble in alkali. If the component (A) is soluble in alkali, it is preferable because development with an alkali aqueous solution can be performed without the use of an organic solvent that may have a large environmental impact. Here, being soluble in alkali means that 0.1 g or more of the component can be dissolved at 25°C in 100 g of a 2.38 mass% aqueous solution of tetramethylammonium hydroxide (TMAH). In order to be soluble in alkali, it is preferable for the component (A) to have an acidic group. Specifically, good examples include, but not limited to, phenolic hydroxyl groups, carboxyl groups, and sulfonic acid groups. Among the acidic groups given above, the use of a phenolic hydroxyl group is preferable from the perspective of storage stability of the negative type photosensitive resin composition, corrosion of the copper wiring, etc.

For the present invention, it is preferable for the component (A) to have a light transmittance per µm film thickness of 90% or more, more preferably 95% or more, and still more preferably 99% or more, at a wavelength of 365 nm. If it is in this range, it serves to produce a negative type photosensitive resin composition that realizes a fine pattern processability even when having a large thickness of 20 µm or more.

Such at least one compound selected from the group consisting of polyamide, polyimide, polybenzoxazole, precursors thereof, and copolymers thereof as mentioned above preferably contains a structure as represented by the formula (1) and/or a structure as represented by the formula (2).

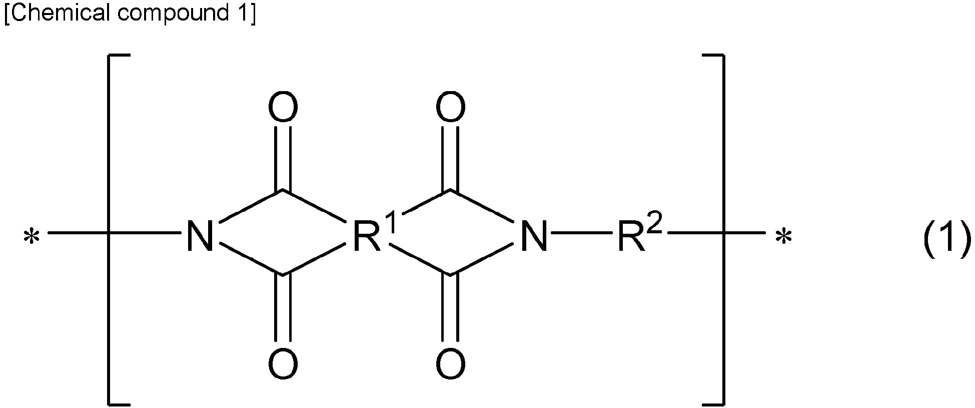

In the formula (1), R¹ is a residue derived from a tetravalent carboxylic acid containing 4 to 40 carbon atoms or a derivative thereof and R² is a divalent diamine containing 4 to 40 carbon atoms or a derivative thereof. In addition, * denotes a bonding point.

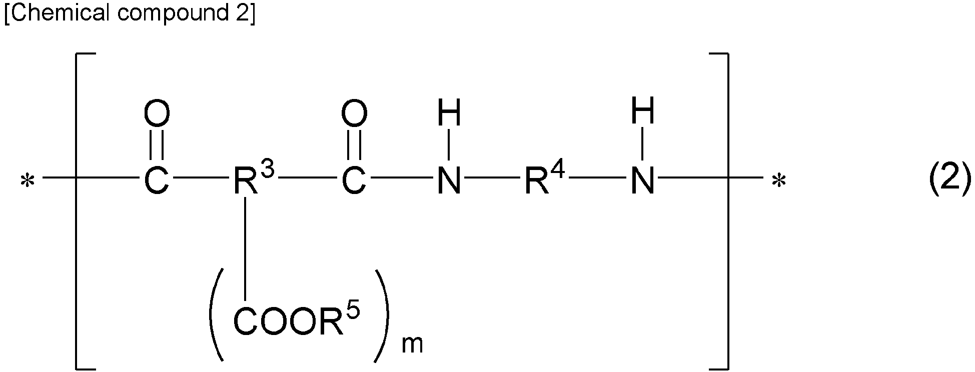

In the formula (2), R³-(COOR⁵)ₘ is a residue derived from a divalent to tetravalent carboxylic acid containing 4 to 40 carbon atoms or a derivative thereof and R⁴ is a residue derived from a divalent diamine containing 4 to 40 carbon atoms or a derivative thereof. R⁵ is a hydrogen atom or a monovalent hydrocarbon group containing 1 to 30 carbon atoms, and m is an integer of 0 to 2. In addition, * denotes a bonding point.

R² in the formula (1) and R⁴ in the formula (2) are each a residue derived from a divalent diamine containing 4 to 40 carbon atoms, and R² and R⁴ are each preferably a diamine residue having a phenolic hydroxyl group. If R² in the formula (1) and R⁴ in the formula (2) are each a diamine residue having a phenolic hydroxyl group, it serves to allow the component (A) to be soluble in alkali.

Examples of such a diamine residue having a phenolic hydroxyl group include, but not limited to, aromatic diamine residues such as bis(3-amino-4-hydroxyphenyl) ether, bis(3-amino-4-hydroxyphenyl) methylene, bis[N-(3-aminobenzoyl)-3-amino-4-hydroxyphenyl] sulfone, bis[N-(4-aminobenzoyl)-3-amino-4-hydroxyphenyl] sulfone, bis(3-amino-4-hydroxyphenyl) sulfone, bis(3-amino-4-hydroxyphenyl) propane, 2,2'-bis[N-(3-aminobenzoyl)-3-amino-4-hydroxyphenyl] propane, 2,2'-bis[N-(4-aminobenzoyl)-3-amino-4-hydroxyphenyl] propane, 9,9-bis(3-amino-4-hydroxyphenyl) fluorene, 9,9-bis[N-(3-aminobenzoyl)-3-amino-4-hydroxyphenyl] fluorene, 9,9-bis[N-(4-aminobenzoyl)-3-amino-4-hydroxyphenyl] fluorene, N,N'-bis(3-aminobenzoyl)-2,5-diamino-1,4-dihydroxybenzene, N,N'-bis(4-aminobenzoyl)-2,5-diamino-1,4-dihydroxybenzene, N,N'-bis(4-aminobenzoyl)-4,4'-diamino-3,3-dihydroxybiphenyl, N,N'-bis(3-aminobenzoyl)-3,3'-diamino-4,4-dihydroxybiphenyl, N,N'-bis(4-aminobenzoyl)-3,3'-diamino-4,4-dihydroxybiphenyl, 3,3'-diamino-4,4'-biphenol, bis(3-amino-4-hydroxyphenyl) methane, 1,1-bis(3-amino-4-hydroxyphenyl) ethane, 2,2-bis(3-amino-4-hydroxyphenyl) propane, and 2,2-bis(3-amino-4-hydroxyphenyl) hexafluoropropane, as well as residues of compounds derived therefrom by substituting part of the hydrogen atoms in the aromatic rings or hydrocarbons with alkyl groups containing 1 to 10 carbon atoms, fluoroalkyl groups, halogen atoms, or the like. Here, the component (A) may contain two or more of these diamine residues.

R² in the formula (1) and R⁴ in the formula (2) may contain a diamine residue having an aromatic ring other than the aforementioned diamine residues having phenolic hydroxyl groups. These are preferably copolymerized because it serves to realize higher heat resistance.

Examples of such a diamine residue having an aromatic ring include, but not limited to, aromatic diamines such as 3,4'-diaminodiphenyl ether, 4,4'-diaminodiphenyl ether, 3,4'-diaminodiphenyl methane, 4,4'-diaminodiphenyl methane, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy) benzene, benzine, m-phenylene diamine, p-phenylene diamine, 1,5-naphthalene diamine, 2,6-naphthalene diamine, bis(4-aminophenoxyphenyl) sulfone, bis(3-aminophenoxyphenyl) sulfone, bis(4-aminophenoxy) biphenyl, bis{4-(4-aminophenoxy)phenyl} ether, 1,4-bis(4-aminophenoxy) benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl, as well as compounds derived therefrom by substituting part of the hydrogen atoms in the aromatic rings or hydrocarbons with alkyl groups containing 1 to 10 carbon atoms, fluoroalkyl groups, halogen atoms, or the like. Here, the component (A) may contain two or more of these diamine residues.

R¹ in the formula (1) is a residue derived from a tetravalent carboxylic acid containing 4 to 40 carbon atoms or a derivative thereof, and R³-(COOR⁵)ₘ in the formula (2) is a residue derived from a divalent to tetravalent carboxylic acid containing 4 to 40 carbon atoms or a derivative thereof. It is preferable that R¹ and R³ be each a carboxylic acid residue having a structure derived from an alicyclic tetracarboxylic dianhydride. If a carboxylic acid residue having a structure derived from an alicyclic tetracarboxylic dianhydride is adopted, it is preferable because it allows the component (A) to have a high light transmittance at a wavelength of 365 nm and show a fine pattern processability even when having a large thickness of 20 µm or more. It is preferable that the component (A) contain a carboxylic acid residue having a structure derived from an alicyclic tetracarboxylic dianhydride because in that case, its cation-polymerizability increases, leading to a cured product with higher heat resistance and chemical resistance as compared with the case where an aromatic dianhydride residue is used, although the mechanism has not been clarified. In addition, in order to provide a cured product with higher chemical resistance and higher ion migration resistance, R¹ in the formula (1) and R³ in the formula (2) are each preferably a tetracarboxylic acid residue having a structure derived from an alicyclic tetracarboxylic dianhydride having a polycyclic structure.

Examples of such an alicyclic tetracarboxylic dianhydride having a polycyclic structure include, but not limited to, residues of 4-(2,5-dioxotetrahydrofuran-3-yl)-1,2,3,4-tetrahydronaphthalene-1,2-dicarboxylic dianhydride, 4-(2,5-dioxotetrahydrofuran-3-yl)-4methyl-1,2,3,4-tetrahydronaphthalene-1,2-dicarboxylic dianhydride, 4-(2,5-dioxotetrahydrofuran-3-yl)-7methyl-1,2,3,4-tetrahydronaphthalene-1,2-dicarboxylic dianhydride, norbornane-2-spiro-2'-cyclopentanone-5'-spiro-2"-norbornane-5,5",6,6"-tetracarboxylic dianhydride, and norbornane-2-spiro-2'-cyclohexanone-6'-spiro-2"-norbornane-5,5",6,6"-tetracarboxylic dianhydride, as well as residues of compounds derived therefrom by substituting part of the hydrogen atoms in the aromatic rings or hydrocarbons with alkyl groups containing 1 to 10 carbon atoms, fluoroalkyl groups, halogen atoms, or the like. Here, the component (A) may contain residues of two or more of these alicyclic tetracarboxylic dianhydrides having polycyclic structures.

As the carboxylic acid residues, it may further contain acid dianhydrides other than the aforementioned alicyclic carboxylic dianhydrides having polycyclic structures. Specific examples include, but not limited to, residues of aromatic tetracarboxylic dianhydrides such as pyromellitic dianhydride, 3,3',4,4'-biphenyl tetracarboxylic dianhydride, 2,3,3',4'-biphenyl tetracarboxylic dianhydride, 2,2',3,3'-biphenyl tetracarboxylic dianhydride, 3,3',4,4'-benzophenone tetracarboxylic dianhydride, 2,2',3,3'-benzophenone tetracarboxylic dianhydride, 2,2-bis(3,4-dicarboxyphenyl) propane dianhydride, 2,2-bis(2,3-dicarboxyphenyl) propane dianhydride, 1,1-bis(3,4-dicarboxyphenyl) ethane dianhydride, 1,1-bis(2,3-dicarboxyphenyl) ethane dianhydride, bis(3,4-dicarboxyphenyl) methane dianhydride, bis(2,3-dicarboxyphenyl) methane dianhydride, bis(3,4-dicarboxyphenyl) sulfone dianhydride, bis(3,4-dicarboxyphenyl) ether dianhydride, 1,2,5,6-naphthalene tetracarboxylic dianhydride, 9,9-bis(3,4-dicarboxyphenyl) fluorene dianhydride, 9,9-bis{4-(3,4-dicarboxyphenoxy)phenyl} fluorene dianhydride, 2,3,6,7-naphthalene tetracarboxylic dianhydride, 2,3,5,6-pyridine tetracarboxylic dianhydride, 3,4,9,10-perylene tetracarboxylic dianhydride, and 2,2-bis(3,4-dicarboxyphenyl) hexafluoropropane dianhydride, and others such as 3,3',4,4'-diphenylsulfone tetracarboxylic dianhydride, 1,2,3,4-cyclobutane tetracarboxylic dianhydride, 1,2,3,4-cyclopentane tetracarboxylic dianhydride, 1,2,4,5-cyclohexane tetracarboxylic dianhydride, 5-(2,5-dioxotetrahydrofuryl)-3-methyl-3-cyclohexene-1,2-dicarboxylic dianhydride, 2,3,5-tricarboxy-2-cyclopentane acetic dianhydride, and 2,3,4,5-tetrahydrofuran tetracarboxylic dianhydride, as well as residues of compounds derived therefrom by substituting part of the hydrogen atoms in the aromatic rings or hydrocarbons with alkyl groups containing 1 to 10 carbon atoms, fluoroalkyl groups, halogen atoms, or the like. Here, the component (A) may contain residues of two or more of these tetracarboxylic dianhydrides.

For the present invention, the molecular chain terminals of the component (A) should be capped with monoamine residues while satisfying the relations 0.6A ≤ B + 0.5C ≤ 0.98A and 0.05(B + C) ≤ C ≤ 0.25(B + C) where A (moles), B (moles), and C (moles) represent the total quantity of carboxylic acid residues, the total quantity of diamine residues, and the total quantity of monoamine residues, respectively, contained in the component (A). If the molecular chain terminals of the component (A) are capped with monoamine residues, it serves to prevent an excessive reaction between the carboxylic acid residues contained in the component (A) and the component (B) and accordingly, the resulting negative type photosensitive resin composition will be prevented from suffering an increase in viscosity when it is stored at room temperature. Specific examples of such monoamine residues include, but not limited to, residues of 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 3-amino-4,6-dihydroxypyrimidine, 2-aminophenol, 3-aminophenol, 4-aminophenol, 2-aminothiophenol, 3-aminothiophenol, and 4-aminothiophenol, as well as residues of compounds derived therefrom by substituting part of the hydrogen atoms in the aromatic rings or hydrocarbons with alkyl groups containing 1 to 10 carbon atoms, fluoroalkyl groups, halogen atoms, or the like. Here, the component (A) may contain two or more of these monamine residues.

For the present invention, it is preferable that the monoamine residues contained in the component (A) have a structure as represented by the formula (3) in order to ensure high storage stability and pattern processability.

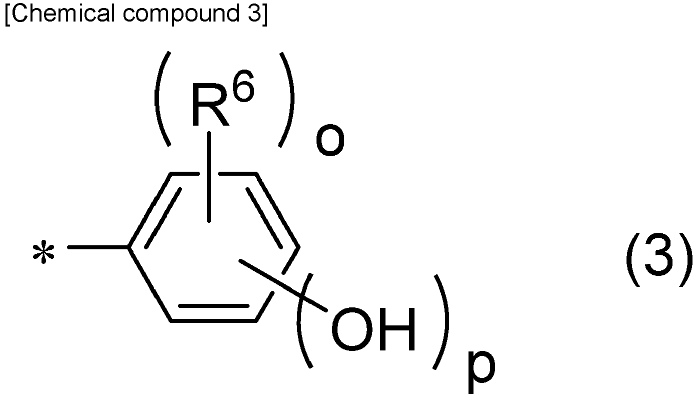

In the formula (3), R⁶ is a monovalent organic group having 1 to 6 carbon atoms; o denotes 0 or 1; p denotes 0 or 1; and * denotes a bonding point.

For the present invention, polyamide, polyimide, and polybenzoxazole, which are typical polymers to include in the component (A), can be synthesized, for example, by the following procedure, though the invention is not limited thereto. Polyimide precursors can be produced by, for example, a procedure in which a tetracarboxylic acid, a derivative thereof, a diamine, a derivative thereof, a monoamine, and a derivative thereof are reacted at a low temperature, or by a procedure in which a diester is prepared from tetracarboxylic acid, a derivative thereof, and alcohol and then reacted with a diamine, a derivative thereof, a monoamine, and a derivative thereof in the presence of a condensing agent. Polyimide can be produced, for example, by heating the above polyimide precursor or reacting it using an acid or base to carry out dehydration and cyclization. A polybenzoxazole precursor can be produced, for example, by using a procedure in which a dicarboxylic acid, a derivative thereof, a diamine having a phenolic hydroxyl group, a derivative thereof, a monoamine, and a derivative thereof are reacted. Polybenzoxazole can be produced, for example, by heating the above polybenzoxazole precursor or reacting it using an acid or base to carry out dehydration and cyclization.

It is preferable that the component (A) synthesized by a method as described above be put in a large amount of water, alcohol, a mixture thereof, or the like, then precipitated, filtered, and dried. The drying temperature is preferably 40°C to 100°C, more preferably 50°C to 80°C. This step works to remove oligomer components such as unreacted monomers, dimers, and trimers, serving to provide a cured product with improved heat resistance and chemical resistance.

The negative type photosensitive resin composition contains a cationic polymerizable compound (B) (hereinafter occasionally referred to as the component (B)). Good substances to use as the component (B) include, but not limited to, cyclic ether compounds such as epoxy compounds and oxetane compounds, ethylenically unsaturated compounds such as vinyl ethers and styrene, and others such as bicyclo-orthoesters, spiro-orthocarbonates, and spiro-orthoesters.

Any appropriate epoxy compound can be used, and examples include aromatic epoxy compounds, alicyclic epoxy compounds, and aliphatic epoxy compounds.

Examples of the aromatic epoxy compounds include, but not limited to, glycidyl ethers of monovalent or multivalent phenols having at least one aromatic ring, such as phenol, bisphenol A, and phenol novolac.

Examples of the alicyclic epoxy compounds include, but not limited to, those produced by epoxidizing, using an oxidizing agent, a compound having at least one unsaturated alicyclic hydrocarbon such as 3,4-epoxycyclohexylmethyl-3,4-epoxycyclohexane carboxylate. Examples of the aliphatic epoxy compounds include, but not limited to, epoxidation products of polyglycidyl ethers of aliphatic polyhydric alcohols such as 1,4-butanediol diglycidyl ether and 1,6-hexanediol diglycidyl ether, polyglycidyl esters of aliphatic polybasic acids such as diglycidyl tetrahydrophthalate, and long chain unsaturated compounds such as epoxidized soybean oil and epoxidized polybutadiene.

Examples of the oxetane compounds include, but not limited to, 3-ethyl-3-hydroxymethyl oxetane, 2-ethylhexyl (3-ethyl-3-oxetanylmethyl) ether, 2-hydroxyethyl (3-ethyl-3-oxetanylmethyl) ether, 2-hydroxypropyl (3-ethyl-3-oxetanylmethyl) ether, 1,4-bis[(3-ethyl-3-oxetanylmethoxy)methyl] benzene, oxetanyl silsesquioxane, and phenolnovolac oxetane.

The ethylenically unsaturated compounds may be, for example, cationic polymerizable monomers, and examples include, but not limited to, aliphatic monovinyl ethers, aromatic monovinyl ethers, polyfunctional vinyl ethers, styrenes, and cationic polymerizable nitrogen-containing monomers.

Examples of the aliphatic monovinyl ethers include, but not limited to, methyl vinyl ether, ethyl vinyl ether, butyl vinyl ether, and cyclohexyl vinyl ether.

Examples of the aromatic monovinyl ethers include, but not limited to, 2-phenoxyethyl vinyl ether, phenylvinyl ether, and p-methoxyphenyl vinyl ether.

Examples of the polyfunctional vinyl ethers include, but not limited to, butanediol-1,4-divinyl ether and triethylene glycol divinyl ether. Examples of the styrenes include, but not limited to, styrene, α-methyl styrene, p-methoxystyrene, and p-(tert-butoxy)styrene. Examples of the cationic polymerizable nitrogen-containing monomers include, but not limited to, N-vinyl carbazol and N-vinyl pyrrolidone.

Examples of the bicyclo-orthoesters include 1-phenyl-4-ethyl-2,6,7-trioxabicyclo[2.2.2] octane and 1-ethyl-4-hydroxymethyl-2,6,7-trioxabicyclo-[2.2.2] octane.

Examples of the spiro-orthocarbonates include 1,5,7,11-tetraoxaspiro[5.5] undecane and 3,9-dibenzyl-1,5,7,11 -tetraoxaspiro[5.5] undecane.

Examples of the spiro-orthoesters include 1,4,6-trioxaspiro[4.4]nonane, 2-methyl-1,4,6-trioxaspiro[4.4]nonane, and 1,4,6-trioxaspiro[4.5]decane.

These cationic polymerizable compounds are preferably epoxy compounds, oxetane compounds, or vinyl ethers, more preferably epoxy compounds or oxetane compounds, and particular preferably epoxy compounds.

It is preferable for the component (B) to contain a polyfunctional epoxy compound (B-1) with an epoxy equivalent weight of 80 g/eq or more and less than 160 g/eq (hereinafter occasionally referred to as the component (B-1)). The inclusion of the component (B-1) is preferable because it serves to produce a cured product having increased heat resistance and chemical resistance.

It is preferable for the component (B-1) to have an octanol-water distribution coefficient (log P value) of -2 or more and less than 5. Here, the log P value is an indicator of the lipophilicity or hydrophilicity of a substance. For a two phase system of octanol and water, it is defined as the logarithm of the ratio between the concentration of the substance dissolved in the octanol phase and the concentration of the substance dissolved in the water phase. A larger log P value indicates a higher lipophilicity while a smaller log P value indicates a higher hydrophilicity. The log P value can be measured by the flask osmosis method specified in JIS Z-7260, but it can also be determined by calculation. For the present Description, the log P value to use is calculated by Chem Draw provided by CambridgeSoft. If the log P value of the component (B-1) is in the range specified above, it is preferable because it ensures a high pattern processability during development with an alkali aqueous solution.

Examples of the component (B-1) having a log P value of -2 or more and less than 5 include, but not limited to, TEPIC-VL (trade name, manufactured by Nissan Chemical Industries, Ltd., log P value -0.01), Shofree PETG, (trade name, manufactured by Showa Denko K.K., log P value -1.93), Shofree free BATG (trade name, manufactured by Showa Denko K.K., log P value 3.44), Denacol EX-810 (trade name, manufactured by Nagase ChemteX Corporation), Denacol EX-211 (trade name, manufactured by Nagase ChemteX Corporation, log P value 0.31), Denacol EX-252, Denacol EX-201 (trade names, manufactured by Nagase ChemteX Corporation, log P value 0.94), and EX-321L (trade name, manufactured by Nagase ChemteX Corporation, log P value -0.81).

It is preferable for the component (B-1) to account for 30 parts by mass or more and 200 parts by mass or less, more preferably 50 to 200 parts by mass, and particularly preferably 50 parts by mass or more and 150 parts by mass or less, relative to 100 parts by mass of the component (A). If the content of the component (B-1) is in the above range, it is preferable because it ensures a sufficient cationic curability and an increased pattern processability in an alkali aqueous solution.

The component (B) preferably includes a component (B-1) and a polyfunctional epoxy compound (B-2) with an epoxy equivalent weight of 160 g/eq or more and less than 500 g/eq (hereinafter occasionally referred to as the component (B-2)) wherein it is preferable that in the component (B), the component (B-1) account for 40 to 99 mass% while the component (B-2) account for 1 to 60 mass% and it is more preferable that in the component (B), the component (B-1) account for 50 to 80 mass% while the component (B-2) account for 20 to 50 mass%. The inclusion of the component (B-2) is preferable because it serves to produce a cured product having better mechanical characteristics. If the contents of the component (B-1) and the component (B-2) are controlled in the above range, it is preferable because it serves to produce a cured product having high heat resistance, high chemical resistance, and good mechanical characteristics.

Examples of the component (B-2) include, but not limited to, TECHMORE VG-3101L (trade name, manufactured by Air Water Inc.), YX-4000H (trade name, manufactured by Mitsubishi Chemical Corporation), YL-983U (trade name, manufactured by Mitsubishi Chemical Corporation), and EPICLON EXA-4850 (trade name, manufactured by DIC Corporation).

In addition, the component (B) as a whole preferably has an epoxy equivalent weight of 80 g/eq or more and 200 g/eq or less, more preferably 90 g/eq or more and 190 g/eq or less, and still more preferably 100 g/eq or more and 180 g/eq or less. If the epoxy equivalent weight of the cationic polymerizable compound (B) as a whole is controlled in the above range, it is preferable because it serves to produce a cured product having high heat resistance, high chemical resistance, and high tensile elongation. Here, the epoxy equivalent weight can be measured by the method specified in JIS K7236: 2001.

There are no specific limitations on the content of the component (B), but it preferably accounts for 30 parts by mass or more and 200 parts by mass or less, more preferably 50 parts by mass or more and 200 parts by mass or less, and particularly preferably 100 parts by mass or more and 150 parts by mass or less, relative to 100 parts by mass of the component (A). If the content of the component (B) is in the above range, it is preferable because it ensures a sufficient cationic curability and an increased pattern processability in an alkali aqueous solution.

The negative type photosensitive resin composition includes a cationic polymerization initiator (C) (hereinafter occasionally referred to as the component (C)). The component (C) is designed to generate an acid when receiving light or heat and promote cationic polymerization. It is preferable for the component (C) to contain a sulfonium salt in order to ensure cationic polymerizability and copper corrosivity.

Examples of cations that form sulfonium salts include, but not limited to, triaryl sulfoniums such as triphenyl sulfonium, tri-p-tolyl sulfonium, tri-o-tolyl sulfonium, tris-(4-methoxyphenyl) sulfonium, 1-naphthyldiphenyl sulfonium, 2-naphthyldiphenyl sulfonium, tris-(4-fluorophenyl) sulfonium, tri-1-naphthyl sulfonium, tri-2-naphthyl sulfonium, tris-(4-hydroxyphenyl) sulfonium, 4-(phenylthio)phenyldiphenyl sulfonium, 4-(p-tolylthio)phenyl-di-p-tolyl sulfonium, 4-(4-methoxyphenylthio)phenyl-bis(4-methoxyphenyl) sulfonium, 4-(phenylthio)phenyl-bis(4-fluorophenyl) sulfonium, 4-(phenylthio)phenyl-bis(4-methoxyphenyl) sulfonium, 4-(phenylthio)phenyl di-p-tolyl sulfonium, [4-(4-biphenylylthio)phenyl]-4-biphenylylphenyl sulfonium, [4-(2-thioxantonylthio)phenyl]diphenyl sulfonium, bis[4-(diphenylsulfonio)phenyl] sulfide, bis[4-{bis[4-(2-hydroxyethoxy)phenyl]sulfonio}phenyl] sulfide, bis{4-[bis(4-fluorophenyl)sulfonio]phenyl} sulfide, bis{4-[bis(4-methylphenyl)sulfonio]phenyl} sulfide, bis{4-[bis(4-methoxyphenyl)sulfonio]phenyl} sulfide, 4-(4-benzoyl-2-chlorophenylthio)phenyl-bis(4-fluorophenyl) sulfonium, 4-(4-benzoyl-2-chlorophenylthio)phenyldiphenyl sulfonium, 4-(4-benzoylphenylthio)phenyl bis(4-fluorophenyl) sulfonium, 4-(4-benzoylphenylthio)phenyldiphenyl sulfonium, 7-isopropyl-9-oxo-10-thia-9,10-dihydroanthracene-2-yl-di-p-tolyl sulfonium, 7-isopropyl-9-oxo-10-thia-9,10-dihydroanthracene-2-yl-diphenyl sulfonium, 2-[(di-p-tolyl)sulfonio]thioxanthone, 2-[(diphenyl)sulfonio]thioxanthone, 4-(9-oxo-9H-thioxanthene-2-yl) thiophenyl-9-oxo-9H-thioxanthene-2-ylphenyl sulfonium, 4-[4-(4-tert-butylbenzoyl)phenylthio]phenyldi-p-tolyl sulfonium, 4-[4-(4-tert-butyl benzoyl)phenylthio]phenyldiphenyl sulfonium, 4-[4-(benzoylphenylthio)]phenyl-di-p-tolyl sulfonium, 4-[4-(benzoylphenylthio)]phenyldiphenyl sulfonium, 5-(4-methoxyphenyl)thianthrenium, 5-phenyl thianthrenium, 5-tolyl thianthrenium, 5-(4-ethoxyphenyl) thianthrenium, and 5-(2,4,6-trimethylphenyl) thianthrenium; diaryl sulfoniums such as diphenylphenacyl sulfonium, diphenyl-4-nitrophenacyl sulfonium, diphenylbenzyl sulfonium, and diphenylmethyl sulfonium; monoaryl sulfoniums such as phenylmethylbenzyl sulfonium, 4-hydroxyphenylmethylbenzyl sulfonium, 4-methoxyphenylmethylbenzyl sulfonium, 4-acetocarbonyloxyphenylmethylbenzyl sulfonium, 4-hydroxyphenyl(2-naphthylmethyl)methyl sulfonium, 2-naphthylmethylbenzyl sulfonium, 2-naphthylmethyl(1-ethoxycarbonyl)ethyl sulfonium, phenylmethylphenacyl sulfonium, 4-hydroxyphenylmethylphenacyl sulfonium, 4-methoxyphenylmethylphenacyl sulfonium, 4-acetocarbonyloxyphenylmethylphenacyl sulfonium, 2-naphthylmethylphenacyl sulfonium, 2-naphthyloctadecylphenacyl sulfonium, and 9-anthracenylmethylphenacyl sulfonium; and others such as dimethylphenacyl sulfonium, phenacyltetrahydrothiophenium, dimethylbenzyl sulfonium, benzyltetrahydrothiophenium, and octadecylmethylphenacyl sulfonium.

From the viewpoint of cationic polymerizability and copper corrosivity, it is preferable that, as a counter anion to form a sulfonium salt, at least one selected from the group consisting of borate ion, phosphate ion, and gallate ion be contained, and the inclusion of a gallate ion is more preferable from the viewpoint of providing a photosensitive resin composition that forms a cured film suffering less yellowing. Here, the borate ion is a complex ion having boron as the central atom, and the phosphate ion is a complex ion having phosphorus as the central atom. The gallate ion is a complex ion having gallium as the central atom.

Examples of the borate ion include, but not limited to, pentafluorophenyl borate, trifluorophenyl borate, tetrafluorophenyl borate, trifluoromethylphenyl borate, bis(trifluoromethyl)phenyl borate, pentafluoroethylphenyl borate, bis(pentafluoroethyl)phenyl borate, fluoro-bis(trifluoromethyl)phenyl borate, fluoro-pentafluoroethylphenyl borate, and fluoro-bis(pentafluoroethyl)phenyl borate.

Examples of the phosphate ion include, but not limited to, hexafluorophosphate and tris-(pentafluoroethyl)trifluorophosphate.

Examples of the gallate ion include, but not limited to, tetrakis(pentafluorophenyl) gallate and tetrakis(3,5-bis(trifluoromethyl)phenyl) gallate.

In regard to the content of the component (C), it preferably accounts for 0.3 part by mass or more and 10 parts by mass or less, more preferably 0.5 part by mass or more and 8 parts by mass or less, and particularly preferably 0.7 part by mass or more and 5 parts by mass or less, relative to 100 parts by mass of the component (B). If the content of the component (C) is adjusted in the above range, it is preferable because it allows the cationic polymerization of the component (B) to proceed sufficiently to realize a higher pattern processability and produce a negative type photosensitive resin composition with a higher storage stability.

The negative type photosensitive resin composition may include a solvent (D). There are no specific limitations on the content of the solvent (D), but it preferably accounts for 100 parts by mass or more and 10,000 parts by mass or less, more preferably 100 parts by mass or more and 5,000 parts by mass or less, and particularly preferably 100 parts by mass or more and 2,000 parts by mass or less, relative to 100 parts by mass of the component (A). If the content of the component (D) is adjusted in the above range, it is preferable because it ensures high coatability and coating film flatness, making it possible to form a coating film with a film thickness of 1 µm or more.

Examples of the component (D) include, but not limited to, γ-butyrolactone, γ-valerolactone, δ-valerolactone, dimethyl sulfoxide, tetrahydrofuran, dioxane, propylene glycol monomethyl ether, propylene glycol monoethyl ether, acetone, methyl ethyl ketone, cyclopentanone, cyclohexanone, ethyl acetate, butyl acetate, isobutyl acetate, propyl acetate, propylene glycol monomethyl ether acetate, 3-methyl-3-methoxybutyl acetate, methyl lactate, ethyl lactate, diacetone alcohol, 3-methyl-3-methoxybutanol, toluene, xylene, N-methyl-2-pyrrolidone, N-ethyl-2-pyrrolidone, N,N-dimethyl formamide, N,N-dimethyl acetamide, 1,3-dimethyl-2-imidazolidinone, N,N'-dimethylpropylene urea, 1,3-dimethylisobutyl amide, methoxy-N,N-dimethylpropione amide, and butoxy-N,N-dimethylpropione amide.

The negative type photosensitive resin composition may contain a sensitizer (E) that acts to absorb ultraviolet light and give the absorbed light energy to the photo-acid generator.

Examples of the component (E) include, but not limited to, 9,10-dialkoxy-anthracene derivatives. Examples of the alkoxy group mentioned above include, but not limited to, alkoxy groups containing 1 to 4 carbon atoms such as methoxy group, ethoxy group, and propoxy group. The 9,10-dialkoxy-anthracene derivatives may further contain substituent groups. Examples of the substituent groups include, but not limited to, halogen atoms such as fluorine, chlorine, bromine, and iodine; alkyl groups containing 1 to 4 carbon atoms such as methyl group, ethyl group, and propyl group; and others such as sulfonic acid alkyl ester groups and carboxylic acid alkyl ester groups. Examples of the alkyl groups contained in the sulfonic acid alkyl ester groups and carboxylic acid alkyl ester groups include, but not limited to, alkyl groups containing 1 to 4 carbon atoms such as methyl, ethyl, and propyl.

The negative type photosensitive resin composition may also include a silane compound (F). The inclusion of the component (F) serves to improve the adhesion between the cured product and the base material.

Examples of the component (F) include, but not limited to, N-phenylaminoethyl trimethoxysilane, N-phenylaminoethyl triethoxysilane, N-phenylaminopropyl trimethoxysilane, N-phenylaminopropyl triethoxysilane, N-phenylaminobutyl trimethoxysilane, N-phenylaminobutyl triethoxysilane, vinyltrimethoxysilane, vinyltriethoxysilane, vinyltrichlorosilane, vinyl-tris-(β-methoxyethoxy)silane, 3-methacryloxypropyl trimethoxysilane, 3-acryloxypropyl trimethoxysilane, p-styryltrimethoxysilane, 3-methacryloxypropylmethyl dimethoxysilane, and 3-methacryloxypropylmethyl diethoxysilane.

The negative type photosensitive resin composition may also contain an antioxidant and/or a surfactant.

In the negative photosensitive resin composition, the content of the fluoride ions (F⁻), chloride ions (Cl⁻), bromide ions (Br), and iodide ions (I⁻) is preferably less than 100 ppm by mass, more preferably 50 ppm by mass or less, and particularly preferably 30 ppm by mass or less. Here, the content means the total content of F-, Cl⁻, Br, and I⁻. Here, each content of F⁻, Cl⁻, Br, and I^{-\} can be analyzed separately by ion chromatography. If the content of F-, Cl⁻, Br, and I⁻ is adjusted in the above range, it is preferable because it ensures increased resistance to ion migration under high temperature and high humidity conditions.

There are no specific limitations on the forms of the negative type photosensitive resin composition before curing, and it may be in the form of, for example, a solution (varnish), coating film, etc. When adopting a negative type photosensitive resin composition in the form of a coating film, it is preferable that a negative type photosensitive resin composition coating film be formed on a support body using the negative type photosensitive resin composition and it is more preferable that a negative type photosensitive resin composition film be formed using a sheet-like support body. As a form other than the negative type photosensitive resin composition film, a supportless structure may also be adopted. A negative type photosensitive resin composition film can be produced, for example, by spreading the negative photosensitive resin composition on a support body and then drying it.

In regard to the negative type photosensitive resin composition film, it is preferable that the negative type photosensitive resin composition coating film has a melt viscosity of 0.5 × 10⁶ MPa·s or more and 1.0 × 10⁷ MPa·s or less at 40°C. If the negative type photosensitive resin composition coating film has a melt viscosity of 0.5 × 10⁶ MPa·s or more at 40°C, the tackiness of the surface of the negative type photosensitive resin composition film at room temperature will be reduced, making the handling of the negative type photosensitive resin composition film easier. If the negative type photosensitive resin composition coating film has a melt viscosity of 1.0 × 10⁷ MPa·s or less at 40°C, it is preferable because cracking of the negative type photosensitive resin composition film at room temperature will be suppressed, allowing the negative type photosensitive resin composition film to suffer less defects and achieve a higher yield. The melt viscosity at 40°C of the negative type photosensitive resin composition coating film can be measured by the procedure described below. First, two layers of the negative type photosensitive resin composition coating films are disposed so that they face each other and they are thermocompression-bonded at 60°C to prepare a layered stack of the photosensitive resin composition coating films. The above operation is carried out repeatedly until the stack of the photosensitive resin composition coating films reaches a thickness of 600 to 700 µm. Then, the stack of the negative type photosensitive resin composition coating films is subjected to measurement by a rheometer under the conditions of a frequency of 0.2 Hz, a strain quantity of 1.0%, and heating from 30°C to 80°C at a rate of 2°C/min and the complex melt viscosity at 40°C is read, thereby determining the melt viscosity at 40°C of the negative type photosensitive resin composition coating film.

In regard to the cured product according to the present invention, the negative type photosensitive resin composition or the negative type photosensitive resin composition coating film is cured to provide a cured product.

The cured product may be in any appropriate form as long as it is prepared by curing the negative type photosensitive resin composition or the negative type photosensitive resin composition coating film by means of light or heat. The curing by means of light or heat can be realized, for example, by carrying out generally known methods such as exposing it to 50 mJ or more and 3,000 mJ or less of a 365 nm i-line, 405 nm h-line, or 432 nm g-line beam emitted from a high pressure mercury lamp to achieve its curing or subjecting it to heat treatment at 150°C or more and 500°C or less for 5 minutes or more and 5 hours or less to achieve its curing.

The production method for a curing product according to the present invention is described below. The cured product production method includes a step for spreading the aforementioned negative type photosensitive resin composition over a substrate followed by drying it to form a negative type photosensitive resin composition coating film on the substrate, a step for applying light to the negative type photosensitive resin composition coating film, a step for developing the negative type photosensitive resin composition coating film to remove the unexposed portions using an alkaline aqueous solution, and a step for heat-treating the developed negative type photosensitive resin composition coating film to form a cured product.

The step for spreading the aforementioned negative type photosensitive resin composition over a substrate followed by drying it to form a negative type photosensitive resin composition coating film on the substrate can be carried out, for example, by way of, but not limited to, spreading the negative type photosensitive resin composition over a substrate using a spin coater, spray coater, screen coater, blade coater, die coater, calendar coater, meniscus coater, bar coater, roll coater, comma roll coater, gravure coater, slit die coater, or the like, followed by drying it at a temperature in the range of 50°C or more and 150°C or less for 1 minute to several hours to form a negative type photosensitive resin composition coating film.

The step for applying light to the negative type photosensitive resin composition coating film can be carried out, for example, by way of, but not limited to, exposing it to 50 mJ or more and 3,000 mJ or less of a 365 nm i-line, 405 nm h-line, or 432 nm g-line beam emitted from a high pressure mercury lamp. The negative type photosensitive resin composition coating film exposed to light in the above step may be subjected to post-exposure baking. The post-exposure baking is performed preferably at 50°C or more from the viewpoint of curability and adhesion to the substrate and preferably at 150°C or less from the viewpoint of resolution.

The step for developing the negative type photosensitive resin composition coating film to remove the unexposed portions using an alkaline aqueous solution can be carried out, for example, by way of, but not limited to, performing techniques such as spraying an alkaline aqueous solution onto the surface of the negative photosensitive resin composition coating film, covering the entire surface with a developing solution, immersing the negative photosensitive resin composition coating film entirely in an alkaline aqueous solution, and applying ultrasonic waves to the immersed negative photosensitive resin composition coating film. The development conditions such as development time and the temperature of the developing solution used in the development step may be set up appropriately so that the exposed portions are removed and pattern formation is achievable. Rinsing with water is preferably performed after the development step. Here, rinsing may be performed with an aqueous solution prepared by adding alcohols such as ethanol and isopropyl alcohol or others such as ethyl lactate and propylene glycol monomethyl ether acetate as required.

The step for heat-treating the developed negative type photosensitive resin composition coating film to form a cured product can be carried out, for example, by way of, but not limited to, heat-curing it at a temperature in the range of 150°C or more and 500°C or less for 5 minutes or more and 5 hours or less to promote the thermal crosslinking reaction, thereby providing a cured product. The heat treatment can be carried out by raising the temperature stepwise to appropriately selected temperatures or raising it continuously over an appropriately selected temperature range. The former procedure may be carried out, for example, by way of, but not limited to, performing heat treatment at 130°C and 200°C for 30 minutes each. The latter procedure may be carried out, for example, by way of, but not limited to, heating it linearly from room temperature to 400°C over 2 hours.

The cured product preferably satisfies the relation T₂/T₁ ≥ 0.98 where T₁ is the film thickness after drying the coated surface and T₂ is the film thickness after curing it at 200°C for 1 hour. If the relation T₂/T₁ ≥ 0.98 is satisfied, it is preferable because it serves to decrease the stress in the cured film.

The hollow structure according to present invention includes a supporting material containing the cured product.

The hollow structure is a structure including a recess or a protrusion and a roof portion provided in an electronic component and it is formed by thermocompression-bonding a film of the negative photosensitive resin composition to the recess or the protrusion. The negative type photosensitive resin composition can be used as a supporting material for the recess or the protrusion. It is preferable for the supporting material in the hollow structure to have a thickness of 5 µm or more and 30 µm or less. It is preferable for the roof portion to have a thickness of 10 µm or more and 30 µm or less. If the supporting material has a thickness of 5 µm or more, it serves to form a hollow structure, whereas if it has a thickness of 30 µm or less, it serves to form a hollow structure that will not suffer the collapse of the roof portion. If the roof portion has a thickness of 10 µm or more, it is preferable because it ensures an increased film strength of the roof portion in the resulting hollow structure, whereas if it has a thickness of 30 µm or less, it allows a thinner hollow structure to be formed, contributing to production of smaller electronic components. It is preferable for the hollow structure to be sealed with a molding resin to produce an electronic component with enhanced robustness. Specifically, it is preferable for the outer periphery of the hollow structure to be sealed with a molding resin. The sealing of the outer periphery of the hollow structure with a molding resin can be carried out, for example, by way of, but not limited to, using the transfer molding technique or the compression molding technique. Such molding techniques as above are designed to pour a sealing resin, which is melted at a temperature of about 180°C, into the space around an electronic component under a pressure of about 6 MPa. Thus, during this sealing step, the roof portion of the hollow structure is subjected to a pressure of about 6 MPa at a high temperature and therefore, if the cured product used to form the roof portion of the hollow structure is low in film strength, it may lead occasionally to deformation of the roof portion and collapse of the structure. In this regard, the existence of the hollow structure is advantageous because it has a sufficient film strength to serve for improving the yield of electronic components in the step for sealing with a molding resin.

The electronic component according to the present invention includes a cured product as described above.

The term "electronic component" refers to any component that can function by making use of the characteristics of semiconductor elements. Any of electrooptical devices and semiconductor circuit boards containing semiconductor elements and substrates connected to each other, structures containing multiple semiconductor elements stacked one on another, and electronic devices incorporating these can be referred to as an electronic component. The cured product is suitably used for various applications such as passivation films for semiconductors, surface protection films for semiconductor elements, interlaminar insulation films between semiconductor elements and wirings, interlaminar insulation films between multiple semiconductor elements, interlaminar insulation films between wiring layers in high-density multilayer interconnection, and insulation layers for organic electroluminescent devices, but its applications are not limited thereto and include various others.

### EXAMPLES

The present invention will be described below with reference to examples, though the present invention is not limited to these examples.

### 1. Evaluation

For the following evaluations, if the number of measurements to take, (n), is not specified otherwise, the evaluation was made based on only one measurement (n = 1).

### (1) Evaluation of transmittance rate

A 40% solution of a polymer compound in GBL was spread on a glass substrate using a spin coater (1H-360S, manufactured by Mikasa Co., Ltd.) and prebaked on a hot plate (SCW-636, manufactured by Dainippon Screen Mfg. Co., Ltd.) at 100°C for 3 minutes to prepare a coat film with a thickness of 1 µm.

For the resulting coat film of the polymer compound, the transmittance rate at 365 nm was measured using an ultraviolet-visible spectrophotometer (U2900, manufactured by Hitachi Ltd.).

### (2) Evaluation of storage stability

A negative type photosensitive resin composition was prepared, and 12 to 24 hours later, the viscosity at 25°C was measured using a type-E viscometer (TVE-25, manufactured by Tohkki Sangyo Co., Ltd.). The measured value was denoted as V₁.

Subsequently, the negative type photosensitive resin composition was sealed and stored at room temperature (23°C) for 2 weeks, and the viscosity was measured and denoted as V₂.

The viscosity increase rate (%) was calculated as (V2 - V1) / V1 × 100, and the storage stability was evaluated according to the following criteria.
Viscosity increase rate is less than 5%: A
Viscosity increase rate is 5% or more and less than 20%: B
Viscosity increase rate is 20% or more: C

### (3) Evaluation of cationic curability

The negative type photosensitive resin composition was spread on a silicon wafer using a spin coater (1H-360S, manufactured by Mikasa Co., Ltd.) and prebaked on a hot plate (SCW-636, manufactured by Dainippon Screen Mfg. Co., Ltd.) at 100°C for 3 minutes to prepare a coat film with a thickness of 20 µm.

Using a parallel light mask aligner (PLA-501F, manufactured by Canon Inc.), a beam of an exposure dose of 300 mJ/cm², 500 mJ/cm², 1,000 mJ/cm², or 2,000 mJ/cm² emitted from a high-pressure mercury lamp used as light source was applied to the resulting coat film through a mask having a line-and-space pattern with a spacing of 10 µm. The exposure dose was calculated from i-line (365 nm) illuminance measurements.

Subsequently, it was subjected to post-exposure baking at 100°C for 3 minutes and developed for a time period twice as long as the time period required for complete dissolution of the unexposed portion in a 2.38 mass% aqueous solution of tetramethylammonium hydroxide (TMAH) using an automatic developing machine (AD-1200, manufactured by Takizawa Sangyo Co., Ltd.), followed by rinsing with pure water for 30 seconds. If it was not developed successfully with the TMAH aqueous solution, development with cyclopentanone (CP) was performed followed by washing with isopropyl alcohol.

Then, the pattern-processed region was observed under an electron microscope.

The cationic curability was evaluated in terms of the smallest of the aforementioned exposure doses at which a pattern was formed successfully without elution.
The smallest exposure dose is 300 mJ/cm²: A
The smallest exposure dose is 500 mJ/cm²: B
The smallest exposure dose is 1,000 mJ/cm²: C
The smallest exposure dose is 2,000 mJ/cm²: D
Elution occurs even at an exposure dose of 2,000 mJ/cm²: E

### (4) Evaluation for pattern processability

A coat film with a thickness of 20 µm was prepared in the same way as in the above section "(3) Evaluation of cationic curability". Using a parallel light mask aligner (PLA-501F, manufactured by Canon Inc.), the resulting coat film was exposed to light emitted from a high-pressure mercury lamp used as light source to the smallest exposure dose at which a pattern with a line width of 20 µm and a space of 10 µm was formed successfully without elution in the above section in (3) through masks having a pattern with a line width of 40 µm and a space of 20 µm, a pattern with a line width of 20 µm and a space of 10 µm, and a pattern with a line width of 15 µm and a space of 5 µm.

Subsequently, it was subjected to post-exposure baking at 100°C for 3 minutes and developed for a time period twice as long as the time period required for complete dissolution of the unexposed portion in a 2.38 mass% aqueous solution of TMAH using an automatic developing machine, followed by rinsing with pure water for 30 seconds. As shown for Example 9 in Table 3, if it was not developed successfully with the TMAH aqueous solution, development with cyclopentanone (CP) was performed followed by washing with isopropyl alcohol.

Then, the pattern-processed region was observed under an electron microscope, and the pattern processability was evaluated in terms of the smallest of the above pattern sizes at which the patter was free of defects such as incomplete removal and elution.
The smallest pattern size without defects is 5 µm: A
The smallest pattern size without defects is 10 µm: B
The smallest pattern size without defects is 20 µm: C
A space of 20 µm is not removed completely: D

In addition, if elution occurred at 2,000 mJ/cm² in the above section (3), the film was rated as E without making an evaluation.

### (5) Evaluation of heat resistance

The negative type photosensitive resin composition was spread on a silicon wafer with a spin coater and prebaked on a hot plate in such a manner that the film after prebaking at 100°C for 3 minutes would have a film thickness of 10 µm, and the entire surface was exposed to light of 2,000 mJ/cm² using a parallel light mask aligner. Then, it was heated up to 200°C at a heating rate of 3.5°C/min in an atmosphere with an oxygen concentration of 20 ppm by mass or less using an inert oven (CLH-21CD-S, manufactured by Koyo Thermo Systems Ltd.), followed by subjecting it to heat treatment at 200°C for 1 hour.

Subsequently, the silicon wafer was immersed in a 45 mass% hydrofluoric acid solution for 5 minutes to peel off the cured film of the negative type photosensitive resin composition from the wafer. Then, it was cut into a size of 3.0 cm × 1.5 cm using a single-edge blade and heated in a nitrogen flow from 25°C to 400°C at a heating rate of 10°C/min while taking measurements using a thermal mechanical analyzer (TMA/SS6100, manufactured by Seiko Instruments Inc.).

The heat resistance was evaluated in terms of the glass transition temperature.
Glass transition temperature is 200°C or more: A
Glass transition temperature is less than 200°C: B

### (6) Evaluation for mechanical characteristics

A cured film was produced by the same procedure as in the section "(5) Evaluation of heat resistance", and this film was peeled off and cut into a strip with a size of 1.5 cm × 9 cm. Using a Tensilon RTM-100 (manufactured by Orientec Co., Ltd.), measurement of tensile elongation (%) and tensile strength (MPa) was performed while pulling the test piece at a tension speed of 50 mm/min (chuck-to-chuck distance 2 cm) in an atmosphere at room temperature of 23°C and a relative humidity of 45.0% RH.

Ten strip-shaped test pieces were prepared from each sample and used for measurement. Then, five largest measured values were selected and their average was calculated.

The mechanical characteristics was evaluated in terms of tensile elongation and tensile strength according to the following criteria.
· Tensile elongation
   Tensile elongation is 30% or more: A
   Tensile elongation is 10% or more and less than 30%: B
   Tensile elongation is less than 10%: C
· Tensile strength
   Tensile strength is 100 MPa or more: A
   Tensile strength is 90 MPa or more and less than 100 MPa: B
   Tensile strength is less than 90 MPa: C

### (7) Evaluation of copper corrosivity

The negative type photosensitive resin composition was spread on a copper-plated substrate with a spin coater and prebaked on a hot plate in such a manner that the film after prebaking at 100°C for 3 minutes would have a film thickness of 10 µm, and the entire surface was exposed to light of 2,000 mJ/cm² using a parallel light mask aligner. Then, it was heated up to 200°C at a heating rate of 3.5°C/min in an atmosphere with an oxygen concentration of 20 ppm by mass or less using an inert oven, followed by subjecting it to heat treatment at 200°C for 1 hour.

The resulting copper-plated substrate coated with a cured film was stored in a high-acceleration aging test chamber (saturated pressure cooker test chamber) for 20 hours under the conditions of 121°C, 100% humidity, and 2 atmospheres, and the discoloration of the copper substrate was evaluated visually.

The heat copper corrosivity was evaluated in terms of the degree of discoloration.
No discoloration is seen: A
Slight brown discoloration is seen: B
Clear brown discoloration is seen: C

### (8) Evaluation of yellowing of cured film

The negative type photosensitive resin composition was spread on a glass plate with a spin coater and prebaked on a hot plate in such a manner that the film after prebaking at 100°C for 3 minutes would have a film thickness of 10 µm, and the entire surface was exposed to light of 2,000 mJ/cm² using a parallel light mask aligner. Then, it was subjected to heat treatment using a hot plate in the atmosphere at 200°C for 1 hour.

Subsequently, the discoloration of the cured film was observed visually, and the yellowing of the cured film was evaluated based on the observation.
No yellowing of the cured film is seen: A
Yellowing is seen: B

### (9) Evaluation for contents of F⁻, Cl⁻; Br-, and I⁻

The negative type photosensitive resin composition was diluted 10 times with ultrapure water and subjected to ultrasonic treatment for 10 minutes, followed by filtering the resulting liquid through a membrane filter with a pore diameter of 0.45 µm to provide a test liquid.

Then, a standard solution of F-, Cl⁻, Br-, or I⁻ ion was injected into an ion chromatography analyzer (ICS-3000, manufactured by Dionex Corp.) to prepare a calibration curve for each ion. Subsequently, 1 mL of the test liquid was injected, and the masses of F⁻, Cl⁻; Br-, and I-ions in the test liquid were determined from the measured peaks and the calibration curves, followed by calculating the total ion mass.

An evaluation for the F-, Cl⁻; Br-, and I⁻ content was made in terms of the ion content calculated as the ion mass relative to the mass of the negative type photosensitive resin composition.
The ion content is less than 30 ppm by mass: A
The ion content is 30 ppm by mass or more and less than 50 ppm by mass: B
The ion content is 50 ppm by mass or more and less than 100 ppm by mass: C
The ion content 100 ppm by mass or more: D

### (10) Evaluation for resistance to ion migration

Except that a substrate for ion migration evaluation (WALTS-TEG ME0102JY, manufactured by WALTS Co., Ltd.) was used as substrate instead of a silicon wafer, a cured film was prepared on the substrate for ion migration evaluation in the same way as in the section "(5) Evaluation of heat resistance".

Then, wires were soldered to the terminals of comb-shaped copper wiring with a line/space of 15 µm/10 µm on the substrate to prepare an evaluation test piece.

The evaluation test piece was put in a HAST apparatus (PM220, manufactured by Kusumoto Chemicals Ltd.) and subjected to ion migration resistance evaluation in an atmosphere at 130°C and 85% RH using an ion migration evaluation apparatus (SIR13, manufactured by Kusumoto Chemicals Ltd.) under the conditions of an applied voltage of 17.5 V and an application time of 96 hours.

An ion migration resistance evaluation was made in terms of the continuous voltage application time required for the resistance value during voltage application to drop below 1.0 × 10⁶ Ω.
The continuous voltage application time is 60 hours or more and less than 96 hours: A
The continuous voltage application time is 30 hours or more and less than 60 hours: B
The continuous voltage application time is less than 30 hours: C

### (11) Evaluation for melt viscosity

The negative type photosensitive resin composition was spread on a PET film with a thickness of 50 µm using a comma roll coater, dried at 120°C for 8 minutes, and laminated with a 10 µm thick PP film as protection film to provide a resin composition film. The thickness of the resin composition film was adjusted to 25 µm.

Two such resin composition films were prepared and deprived of the protection films, and the resin composition films were placed in such a manner that the resin composition coating films face each other and thermocompression-bonded at 60°C to provide a stack of resin composition coating films (stacked resin composition coating films).

Then, the stacked resin composition coating films prepared by removing PET films from the stacked resin composition coating films were placed to face with the resin composition coating film of another resin composition film deprived of its protection film, and they were thermocompression-bonded together as described above. This stacking operation was repeated until the thickness of the stacked resin composition coating films reached 600 to 700 µm.

Then, the stack of resin composition coating films was heated from 30°C to 80°C at a rate of 2°C/min and subjected to measurement under the conditions of a frequency of 0.2 Hz and a strain quantity of 1.0% using a rheometer (MCR302, manufactured by Anton Paar) equipped with disposable parallel plates with a diameter of 15 mm, and the complex melt viscosity at 40°C was read.

### (12) Evaluation for stress in cured film

A cured film was formed on a silicon wafer in the same way as in the section "(5) Evaluation of heat resistance", and an evaluation for stress in the cured film was made using a stress measurement device (FLX2908, manufactured by KLA Tencor).

Assuming that the substrate had an elastic modulus of 1.805 and a thickness of 775 µm, the change in the radius of curvature of the silicon wafer between before and after the formation of the cured film was measured at 25°C using a laser with a wavelength of 670 nm, and the stress in the cured film was calculated using the Stoney formula.

### 2. Synthesis of polyimide

### (A) Synthesis of polymer compounds (P1) to (P18)

### [Synthesis example 1 Synthesis of polyimide (P1)]

In a dry nitrogen flow, 4,4'-oxydiphthalic anhydride (hereinafter ODPA) (31.02 g, 0.1 mol) was added to 100 g of γ-butyrolactone (hereinafter GBL) and dissolved while stirring at 60°C. Then, 2-aminobenzoic acid (1.37 g, 0.01 mol, 10 mol% relative to all amines and derivatives thereof) and 2,2-bis(3-amino-4-hydroxyphenyl) hexafluoropropane (hereinafter BAHF) (32.96 g, 0.09 mol, 90 mol% relative to all amines and derivatives thereof) were added, and the mixture was stirred at 60°C for 1 hour, followed by heating to 200°C and stirring for 4 hours. The reaction solution was left to stand to cool to provide a GBL solution of polyimide (P1).

### [Synthesis example 2 Synthesis of polyimide (P2)]

In a dry nitrogen flow, ODPA (31.02 g, 0.1 mol) was added to 100 g of GBL and dissolved while stirring at 60°C. Then, 3-aminophenol (hereinafter MAP) (1.09 g, 0.01 mol, 10 mol% relative to all amines and derivatives thereof) and BAHF (32.96 g, 0.09 mol, 90 mol% relative to all amines and derivatives thereof) were added, and the mixture was stirred at 60°C for 1 hour, followed by heating to 200°C and stirring for 4 hours. The reaction solution was left to stand to cool to provide a GBL solution of polyimide (P2).

### [Synthesis example 3 Synthesis of polyimide (P3)]

In a dry nitrogen flow, 4-(2,5-dioxotetrahydrofuran-3-yl)-1,2,3,4-tetrahydronaphthalene-1,2-dicarboxylic dianhydride (hereinafter TDA-100) (30.03 g, 0.1 mol) was added to 100 g of GBL and dissolved while stirring at 60°C. Then, MAP (1.09 g, 0.01 mol, 10 mol% relative to all amines and derivatives thereof) and BAHF (32.96 g, 0.09 mol, 90 mol% relative to all amines and derivatives thereof) were added, and the mixture was stirred at 60°C for 1 hour, followed by heating to 200°C and stirring for 4 hours. The reaction solution was left to stand to cool to provide a GBL solution of polyimide (P3).

### [Synthesis example 4 Synthesis of polyimide (P4)]

In a dry nitrogen flow, 4-(2,5-dioxotetrahydrofuran-3-yl)-1,2,3,4-tetrahydronaphthalene-1,2-dicarboxylic dianhydride (hereinafter TDA-100) (30.03 g, 0.1 mol) was added to 100 g of GBL, and dissolved while stirring at 60°C. Then, MAP (1.74 g, 0.016 mol, 15 mol% relative to all amines and derivatives thereof) and BAHF (32.96 g, 0.09 mol, 85 mol% relative to all amines and derivatives thereof) were added, and the mixture was stirred at 60°C for 1 hour, followed by heating to 200°C and stirring for 4 hours. The reaction solution was left to stand to cool to provide a GBL solution of polyimide (P4).

### [Synthesis example 5 Synthesis of polyimide (P5)]

In a dry nitrogen flow, 4-(2,5-dioxotetrahydrofuran-3-yl)-1,2,3,4-tetrahydronaphthalene-1,2-dicarboxylic dianhydride (hereinafter TDA-100) (30.03 g, 0.1 mol) was added to 100 g of GBL, and dissolved while stirring at 60°C. Then, MAP (1.09 g, 0.01 mol, 14 mol% relative to all amines and derivatives thereof) and BAHF (21.98 g, 0.06 mol, 86 mol% relative to all amines and derivatives thereof) were added, and the mixture was stirred at 60°C for 1 hour, followed by heating to 200°C and stirring for 4 hours. The reaction solution was left to stand to cool to provide a GBL solution of polyimide (P5).

### [Synthesis example 6 Synthesis of polyimide (P6)]

In a dry nitrogen flow, 4-(2,5-dioxotetrahydrofuran-3-yl)-1,2,3,4-tetrahydronaphthalene-1,2-dicarboxylic dianhydride (hereinafter TDA-100) (30.03 g, 0.1 mol) was added to 100 g of GBL and dissolved while stirring at 60°C. Then, MAP (2.73 g, 0.025 mol, 24 mol% relative to all amines and derivatives thereof) and BAHF (29.30 g, 0.08 mol, 76 mol% relative to all amines and derivatives thereof) were added, and the mixture was stirred at 60°C for 1 hour, followed by heating to 200°C and stirring for 4 hours. The reaction solution was left to stand to cool to provide a GBL solution of polyimide (P6).

### [Synthesis example 7 Synthesis of polyimide (P7)]

In a dry nitrogen flow, 4-(2,5-dioxotetrahydrofuran-3-yl)-1,2,3,4-tetrahydronaphthalene-1,2-dicarboxylic dianhydride (hereinafter TDA-100) (30.03 g, 0.1 mol) was added to 100 g of GBL and dissolved while stirring at 60°C. Then, MAP (0.55 g, 0.005 mol, 5 mol% relative to all amines and derivatives thereof) and BAHF (32.96 g, 0.09 mol, 95 mol% relative to all amines and derivatives thereof) were added, and the mixture was stirred at 60°C for 1 hour, followed by heating to 200°C and stirring for 4 hours. The reaction solution was left to stand to cool to provide a GBL solution of polyimide (P7).

### [Synthesis example 8 Synthesis of the polyamide (P8)]

In a dry nitrogen flow, BAHF (32.96 g, 0.09 mol, 90 mol% relative to all amines and derivatives thereof) and MAP (1.09 g, 0.01 mol, 10 mol% relative to all amines and derivatives thereof) were added to 100 g of GBL and dissolved while stirring at room temperature. Then, while maintaining the temperature of the reaction solution at -10°C to 0°C, 4,4'-diphenylether dicarboxylic acid dichloride (29.52 g, 0.1 mol) was added little by little, and after the completion of the addition, the mixture was warmed to room temperature and stirred for 3 hours. Subsequently, the reaction solution was poured into 3 L of water to cause precipitation and the resulting precipitate was collected by filtration, washed with water three times, and dried in a vacuum drier at 80°C for 5 hours to provide polyamide (P8).

### [Synthesis example 9 Synthesis of polybenzoxazole (P9)]

In a dry nitrogen flow, BAHF (32.96 g, 0.09 mol, 90 mol% relative to all amines and derivatives thereof) and MAP (1.09 g, 0.01 mol, 10 mol% relative to all amines and derivatives thereof) were added to 100 g of GBL and dissolved while stirring at room temperature. Then, 1,2-bis(4-formylphenyl) ethane (hereinafter BFE) (23.6 g, 0.10 mol) was added little by little, and the mixture was stirred at 20°C for 1 hour and additionally stirred at 50°C for 1 hour. Subsequently, it was heated to 200°C and stirred for 4 hours. The reaction solution was left to stand to cool to provide a GBL solution of polybenzoxazole (P9).

### [Synthesis example 10 Synthesis of polyimide precursor (P10)]

In a dry nitrogen flow, ODPA (31.02g, 0.10 mole) was dissolved in 200 g of GBL. To this liquid, BAHF (32.96 g, 0.09 mol, 90 mol% relative to all amines and derivatives thereof) was added, and the mixture was stirred at 20°C for 1 hour and additionally stirred at 50°C for 2 hours. Then, MAP (1.09 g, 0.01 mol, 10 mol% relative to all amines and derivatives thereof) was added, and the mixture was stirred at 50°C for 2 hours. After that, a solution prepared by diluting N,N-dimethylformamide dimethylacetal (21.5 g, 0.18 mol) with 20 g of GBL was added little by little and then stirred at 50°C for 3 hours. Subsequently, the reaction solution was left to stand to cool and poured into 3 L of water to cause precipitation and the resulting precipitate was collected by filtration, washed with water three times, and dried in a vacuum drier at 80°C for 5 hours to provide a polyamide precursor (P10).

### [Synthesis example 11 Synthesis of polybenzoxazole precursor (P11)]

In a dry nitrogen flow, BAHF (32.96 g, 0.09 mol, 90 mol% relative to all amines and derivatives thereof) and MAP (1.09 g, 0.01 mol, 10 mol% relative to all amines and derivatives thereof) were added to 100 g of GBL and dissolved while stirring at room temperature. Then, BFE (23.6g, 0.10 mol) was added little by little, and the mixture was stirred at 20°C for 1 hour and additionally stirred at 50°C for 1 hour. The reaction solution was left to stand to cool to provide a GBL solution of polybenzoxazole precursor (P11).

### [Synthesis example 12 Synthesis of polyimide (P12)]

In a dry nitrogen flow, ODPA (31.02 g, 0.1 mol) was added to 100 g of GBL and dissolved while stirring at 60°C. Then, BAHF (32.96 g, 0.09 mol) was added and the mixture was stirred at 60°C for 1 hour, subsequently heated to 200°C, and stirred for 4 hours. The reaction solution was left to stand to cool to provide a GBL solution of polyimide (P12).

### [Synthesis example 13 Synthesis of polyimide (P13)]

In a dry nitrogen flow, TDA-100 (30.03 g, 0.10 mol) was added to 100 g of GBL and dissolved while stirring at 60°C. Then, BAHF (32.96 g, 0.09 mol) was added and the mixture was stirred at 60°C for 1 hour, subsequently heated to 200°C, and stirred for 4 hours. The reaction solution was left to stand to cool to provide a GBL solution of polyimide (P13).

### [Synthesis example 14 Synthesis of polyimide (P14)]

In a dry nitrogen flow, TDA-100 (30.03 g, 0.10 mol) was added to 100 g of GBL and dissolved while stirring at 60°C. Then, BAHF (32.96 g, 0.09 mol) and MAP (0.218 g, 0.002 mol) were added and the mixture was stirred at 60°C for 1 hour, subsequently heated to 200°C, and stirred for 4 hours. The reaction solution was left to stand to cool to provide a GBL solution of polyimide (P14).

### [Synthesis example 15 Synthesis of polyimide (P15)]

In a dry nitrogen flow, TDA-100 (30.03 g, 0.10 mol) was added to 100 g of GBL and dissolved while stirring at 60°C. Then, BAHF (29.29 g, 0.08 mol) and MAP (3.27 g, 0.03 mol) were added and the mixture was stirred at 60°C for 1 hour, subsequently heated to 200°C, and stirred for 4 hours. The reaction solution was left to stand to cool to provide a GBL solution of polyimide (P15).

### [Synthesis example 16 Synthesis of polyimide (P16)]

In a dry nitrogen flow, TDA-100 (30.03 g, 0.10 mol) was added to 100 g of GBL and dissolved while stirring at 60°C. Then, BAHF (32.96 g, 0.09 mol) and MAP (2.18 g, 0.02 mol) were added and the mixture was stirred at 60°C for 1 hour, subsequently heated to 200°C, and stirred for 4 hours. The reaction solution was left to stand to cool to provide a GBL solution of polyimide (P16).

### [Synthesis example 17 Synthesis of polyimide (P17)]

In a dry nitrogen flow, TDA-100 (30.03 g, 0.10 mol) was added to 100 g of GBL and dissolved while stirring at 60°C. Then, BAHF (18.31 g, 0.05 mol) and MAP (1.09 g, 0.01 mol) were added and the mixture was stirred at 60°C for 1 hour, subsequently heated to 200°C, and stirred for 4 hours. The reaction solution was left to stand to cool to provide a GBL solution of polyimide (P17).

Lists of the components used in the above synthesis examples are given in Table 1.

Each sample is shown to be "good" or "not good" if it satisfies or fails to satisfy, respectively, the relations 0.6 A ≤ B+0.5 C ≤ 0.98 A and 0.05(B+C) ≤ C ≤ 0.25(B+C) where A (moles), B (moles), and C (moles) represent the quantities of carboxylic acid residues, diamine residues, and monoamine residues, respectively.

### [Synthesis example 18 Synthesis of polyimide precursor (P18)]

In a dry nitrogen flow, ODPA (31.02 g, 0.10 mole) was dissolved in 200 g of GBL. To this liquid, BAHF (32.96 g, 0.09 mol, 90 mol% relative to all amines and derivatives thereof) was added, and the mixture was stirred at 20°C for 1 hour and additionally stirred at 50°C for 2 hours. After that, a solution prepared by diluting N,N-dimethylformamide dimethylacetal (21.5 g, 0.18 mol) with 20 g of GBL was added little by little and then stirred at 50°C for 3 hours. Subsequently, the reaction solution was left to stand to cool and poured into 3 L of water to cause precipitation and the resulting precipitate was collected by filtration, washed with water three times, and dried in a vacuum drier at 80°C for 5 hours to provide a polyamide precursor (P18).

Table 1 shows the types (name of relevant compound) and quantities of the residues contained in P1 to P18 and gives "good" or "not good" to show whether the samples satisfied or failed to satisfy, respectively, the relations 0.6A ≤ B + 0.5 C ≤ 0.98A (requirement (ii-1)) and 0.05(B + C) ≤ C ≤ 0.25(B + C) (requirement (ii-2)) where A (moles), B (moles), and C (moles) represent the quantities of carboxylic acid residues, diamine residues, and monoamine residues, respectively, contained in the component (A).

### [Table 1]

**[Table 1]**

| component (A) | molar ratio A of carboxylic acid derivative | | | | molar ratio B of diamine | molar ratio C of monoamine | | requirement (ii-1) satisfied or not | requirement (ii-2) satisfied or not |
|---|---|---|---|---|---|---|---|---|---|
| | ODPA | TDA-100 | 4,4'-diphenyl ether dicarboxylic acid dichloride | BFE | BAHF | 2-aminobenzoic acid | MAP | | |
| P1 | 100 | - | - | - | 90 | 10 | - | satisfied | satisfied |
| P2 | 100 | - | - | - | 90 | - | 10 | satisfied | satisfied |
| P3 | - | 100 | - | - | 90 | - | 10 | satisfied | satisfied |
| P4 | - | 100 | - | - | 90 | - | 16 | satisfied | satisfied |
| P5 | - | 100 | - | - | 60 | - | 10 | satisfied | satisfied |
| P6 | - | 100 | - | - | 80 | - | 25 | satisfied | satisfied |
| P7 | - | 100 | - | - | 90 | - | 5 | satisfied | satisfied |
| P8 | - | - | 100 | - | 90 | - | 10 | satisfied | satisfied |
| P9 | - | - | - | 100 | 90 | - | 10 | satisfied | satisfied |
| P10 | 100 | - | - | - | 90 | - | 10 | satisfied | satisfied |
| P11 | - | - | - | 100 | 90 | - | 10 | satisfied | satisfied |
| P12 | 100 | - | - | - | 90 | - | - | satisfied | not satisfied |
| P13 | - | 100 | - | - | 90 | - | - | satisfied | not satisfied |
| P14 | - | 100 | - | - | 90 | - | 2 | satisfied | not satisfied |
| P15 | - | 100 | - | - | 80 | - | 30 | satisfied | not satisfied |
| P16 | - | 100 | - | - | 90 | - | 20 | not satisfied | satisfied |
| P17 | - | 100 | - | - | 50 | - | 10 | not satisfied | satisfied |
| P18 | 100 | - | - | - | 90 | - | - | satisfied | not satisfied |

The samples of P1 to P11 satisfy both the relation 0.6A ≤ B + 0.5 C ≤ 0.98A [requirement (ii-1)] and the relation 0.05(B + C) ≤ C ≤ 0.25(B + C) [requirement (ii-2)], whereas the samples of P12 to P18 fail to satisfy either the relation 0.6A ≤ B+0.5 C ≤ 0.98A [requirement (ii-1)] or the relation 0.05(B + C) ≤ C ≤ 0.25(B + C) [requirement (ii-2)].

3. Synthesis of sulfonium salt (M-1) containing gallate ion as cationic polymerization initiator (C)

### [Synthesis example 19 Synthesis of sulfonium salt (M-1) containing gallate ion]

First, [4-(phenylthio)phenyl] sulfonium triflate (4.16 g, 0.008 mol) was dissolved in 200 g of dichloromethane, and 250 g of an aqueous solution containing an equimolar amount of lithium tetrakis(pentafluorophenyl)gallate was mixed with it at room temperature, and the resulting mixture was stirred for 3 hours. After the stirring step, the dichloromethane layer was washed twice with water for liquid-liquid separation and transferred to a rotary evaporator, in which the solvent was evaporated to provide a sulfonium salt (M-1) containing the gallate ion.

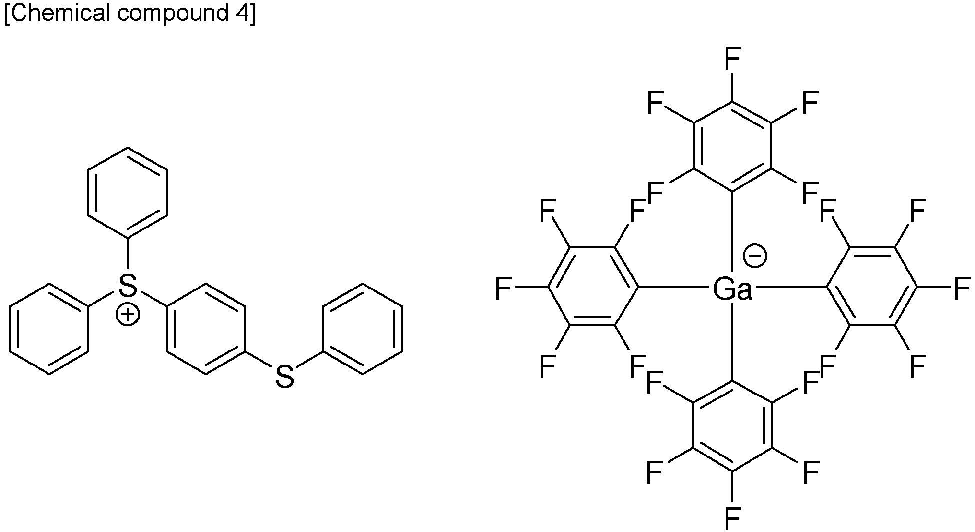

### 4. Compounds used in examples and comparative examples

### (A) Polymer compounds

P1 to P7: The polymer compounds produced in [Synthesis example 1] to [Synthesis example 7], which are polyimides that satisfy [requirement (i)] and also satisfy both [requirement (ii-1)] 0.6A ≤ B + 0.5C ≤ 0.98A, and [requirement (ii-2)] 0.05(B + C) ≤ C ≤ 0.25(B + C).

P8: The polymer compound produced in [Synthesis example 8], which is a polyamide that satisfies [requirement (i)] and also satisfies both [requirement (ii-1)] 0.6A ≤ B + 0.5C ≤ 0.98A and [requirement (ii-2)] 0.05(B + C) ≤ C ≤ 0.25(B + C).

P9: The polymer compound produced in [Synthesis example 9], which is a polybenzoxazole that satisfies [requirement (i)] and also satisfies both [requirement (ii-1)] 0.6A ≤ B + 0.5C ≤ 0.98A and [requirement (ii-2)] 0.05(B + C) ≤ C ≤ 0.25(B + C).

P10: The polymer compound produced in [Synthesis example 10], which is a polyimide precursor that satisfies [requirement (i)] and also satisfies both [requirement (ii-1)] 0.6A ≤ B + 0.5C ≤ 0.98A and [requirement (ii-2)] 0.05(B + C) ≤ C ≤ 0.25(B + C).

P11: The polymer compound produced in [Synthesis example 11], which is a polybenzoxazole precursor that satisfies [requirement (i)] and also satisfies both [requirement (ii-1)] 0.6A ≤ B + 0.5C ≤ 0.98A and [requirement (ii-2)] 0.05(B + C) ≤ C ≤ 0.25(B + C).

P12 to P17: The polymer compounds produced in [Synthesis example 12] to [Synthesis example 17], which are polyimides that satisfy [requirement (i)], but fail to satisfy either [requirement (ii-1)] 0.6A ≤ B + 0.5C ≤ 0.98A or [requirement (ii-2)] 0.05(B + C) ≤ C ≤ 0.25(B + C).

P18: The polymer compound produced in [Synthesis example 18], which is a polyimide precursor that satisfies [requirement (i)] and [requirement (ii-1)] 0.6A ≤ B + 0.5C ≤ 0.98A, but fails to satisfy [requirement (ii-2)] 0.05(B + C) ≤ C ≤ 0.25(B + C).

### 1007: Bis-A type phenoxy resin (manufactured by Mitsubishi Chemical Corporation) [a polymer compound that does not satisfy requirement (i)]

### (B) Cationic polymerizable compound

### Component (B-1)

TEPIC-VL: (manufactured by Nissan Chemical Industries, Ltd.), epoxy equivalent weight = 128 g/eq, log P value = -0.01
PETG: (manufactured by Showa Denko K.K.), epoxy equivalent weight = 90 g/eq, log P value = -1.93
BATG: (manufactured by Showa Denko K.K.), epoxy equivalent weight = 113 g/eq, log P value = 3.44
Tetramethylbiphenyl oxirane: 4,4'-bis(2,3-epoxy)-3,3',5,5'tetramethylbiphenyl, epoxy equivalent weight = 147 g/eq, log P value = 5.26

### Component (B-2)

EXA-4850-150: (manufactured by DIC Corporation), epoxy equivalent weight = 450 g/eq
YX-4000H: (manufactured by Mitsubishi Chemical Corporation), epoxy equivalent weight = 176 g/eq
YL-983U: (manufactured by Mitsubishi Chemical Corporation), epoxy equivalent weight = 175 g/eq
EXA-4816: (manufactured by DIC Corporation), epoxy equivalent weight = 403 g/eq

### (C) Cationic Polymerization Initiator

WPI-116: (manufactured by FUJIFILM Wako Pure Chemical Corporation) iodonium salt
WPAG-370: (manufactured by FUJIFILM Wako Pure Chemical Corporation) sulfonium salt
M-1: [Synthesis example 19] sulfonium salt containing gallate ion
CPI-310B: (manufactured by San-Apro Ltd.) sulfonium salt containing borate ion 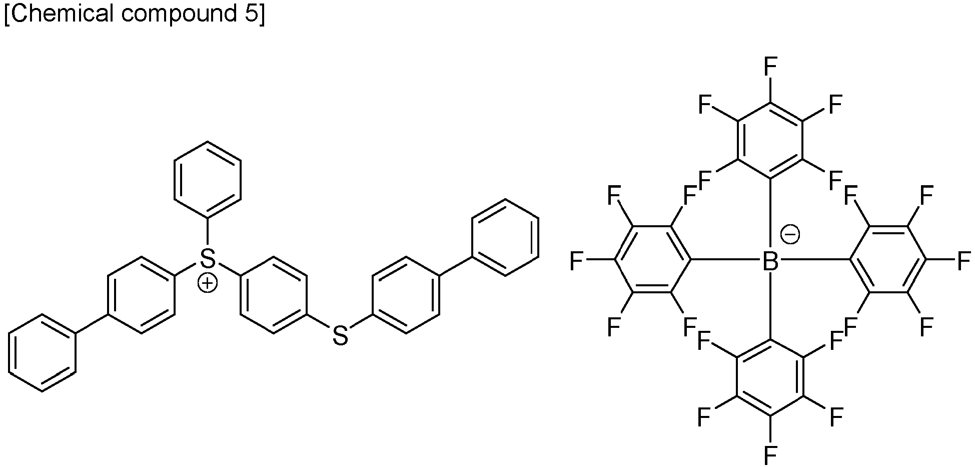
CPI-410S: (manufactured by San-Apro Ltd.) sulfonium salt containing phosphate ion

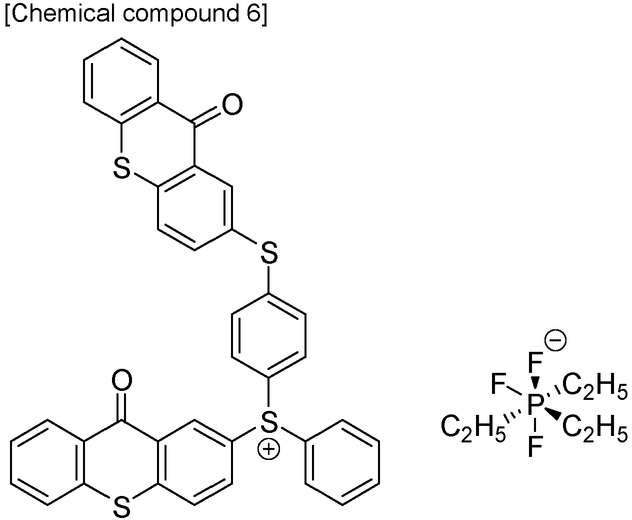

### (D) Solvent

γ- butyrolactone (GBL)

### (E) Sensitizer

UVS-2171 (manufactured by Kawasaki Kasei Chemicals Ltd.)

### (F) Silane compound

KBM303 (manufactured by Shin-Etsu Chemical Co., Ltd.)

### [Example 1]

A small amount of the GBL solution of polyimide (P1) produced in Synthesis example 1 was weighed out and put in an aluminum cup with a known weight. The total weight was measured and the weight of the aluminum cup was subtracted to provide a weight I. Then, the solvent was removed by heating at 250°C for 1 hour and the total weight was measured, followed by subtracting the weight of the aluminum cup to provide a weight II. Based on the solid content concentration calculated as II/I, GBL was added to the GBL solution of polyimide (P1) to adjust the polyimide (P1) content to 40 mass% to provide a 40 mass% solution of polyimide (P1) in GBL.

An evaluation for the transmittance of the polyimide (P1) was made according to the evaluation method described in the section (1) above. Next, under yellow light, a mixture was prepared by combining 25 g of a 40% GBL solution of polyimide (P1), 12 g of TEPIC-VL as the cationic polymerizable compound (B), 0.6 g of WPI-116 as the cationic polymerization initiator (C), 5 g of GBL as the solvent (D), 0.4 g of UVS-2171 as the sensitizer, and 0.85 g of KBM-303 as the silane compound, and it was subjected to pressure filtration using a filter with a particle filtering diameter of 1 µm to provide a negative type photosensitive resin composition. The storage stability, cationic curability, pattern processability, heat resistance, mechanical characteristics, and copper corrosivity of the negative type photosensitive resin composition were evaluated according to the evaluation methods described in the sections (2) to (7) above.

### [Example 2] to [Example 30]

In the same way as in Example 1, GBL was added to the solution of the polymer compound (A) to prepare a 40% GBL solution of the polymer compound (A). An evaluation for the transmittance of the polymer compound (A) was made according to the evaluation method described in the section (1) above.

Negative type photosensitive resin compositions were prepared in the same way as in Example 1 using the components (A) to (D) in combination with other components as listed in Table 2, and the storage stability, cationic curability, pattern processability, heat resistance, and mechanical characteristics of the negative type photosensitive resin compositions were evaluated according to the evaluation methods described in the sections (2) to (7) above.

### [Comparative examples 1] to [Comparative example 8]

In the same way as in Example 1, GBL was added to the polymer compound (A) or a solution thereof in such a manner that the polymer compound (A) accounted for 40 mass% in the solution. An evaluation for the transmittance of the polymer compound (A) was made according to the evaluation method described in the section (1) above. The polymer compounds used as the component (A) were as listed in Table 2.

Negative type photosensitive resin compositions were prepared in the same way as in Example 1 using the components (A) to (D) in combination with other components as listed in Table 2, and the storage stability, cationic curability, pattern processability, heat resistance, mechanical characteristics, and copper corrosivity of the negative type photosensitive resin compositions were evaluated according to the evaluation methods described in the sections (2) to (7) above.

### [Table 2-1]

**[Table 2-1]**

| | components of photosensitive resin composition (content/g) | | | | | |
|---|---|---|---|---|---|---|
| | polymer compound (A) | cationic polymerizable compound (B) | | (C) cationic polymerization initiator | other components | log P value of component (B-1) |
| | | component (B-1) | component (B-2) | | | |
| Example 1 | 40% GBL solution of P1 (25) | TEPIC-VL (12) | - | WPI-116 (0.6) | GBL (5) | -0.01 |
| | | | | | UVS-2171 (0.4) | |
| | | | | | KBM-303 (0.85) | |
| Example 2 | 40% GBL solution of P2 (25) | TEPIC-VL (12) | - | WPI-116 (0.6) | GBL (5) | -0.01 |
| | | | | | UVS-2171 (0.4) | |
| | | | | | KBM-303 (0.85) | |
| Example 3 | 40% GBL solution of P3 (25) | TEPIC-VL (12) | - | WPI-116 (0.6) | GBL (5) | -0.01 |
| | | | | | UVS-2171 (0.4) | |
| | | | | | KBM-303 (0.85) | |
| Example 4 | 40% GBL solution of P3 (25) | TEPIC-VL (12) | - | WPAG-370 (0.6) | GBL (5) | -0.01 |
| | | | | | UVS-2171 (0.4) | |
| | | | | | KBM-303 (0.85) | |
| Example 5 | 40% GBL solution of P3 (25) | TEPIC-VL (12) | - | CPI-310B (0.6) | GBL (5) | -0.01 |
| | | | | | UVS-2171 (0.4) | |
| | | | | | KBM-303 (0.85) | |
| Example 6 | 40% GBL solution of P3 (25) | TEPIC-VL (12) | - | CPI-410S (0.6) | GBL (5) | -0.01 |
| | | | | | UVS-2171 (0.4) | |
| | | | | | KBM-303 (0.85) | |
| Example 7 | 40% GBL solution of P3 (25) | TEPIC-VL (12) | - | (M-1) (0.6) | GBL (5) | -0.01 |
| | | | | | UVS-2171 (0.4) | |
| | | | | | KBM-303 (0.85) | |
| Example 8 | 40% GBL solution of P3 (25) | TEPIC-VL (10) | - | (M-1) (0.6) | GBL (5) | -0.01 |
| | | | | | UVS-2171 (0.4) | |
| | | | | | KBM-303 (0.85) | |
| Example 9 | 40% GBL solution of P3 (25) | TEPIC-VL (15) | - | (M-1) (0.6) | GBL (5) | -0.01 |
| | | | | | UVS-2171 (0.4) | |
| | | | | | KBM-303 (0.85) | |
| Example 10 | 40% GBL solution of P3 (25) | PETG (12) | - | (M-1) (0.6) | GBL (5) | -1.93 |
| | | | | | UVS-2171 (0.4) | |
| | | | | | KBM-303 (0.85) | |

### [Table 2-2]

**[Table 2-2]**

| | components of photosensitive resin composition (content/g) | | | | | |
|---|---|---|---|---|---|---|
| | polymer compound (A) | cationic polymerizable compound (B) | | (C) cationic polymerization initiator | other components | log P value of component (B-1) |
| | | component (B-1) | component (B-2) | | | |
| Example 11 | 40% GBL solution of P3 (25) | BATG (12) | - | (M-1) (0.6) | GBL (5) | 3.44 |
| | | | | | UVS-2171 (0.4) | |
| | | | | | KBM-303 (0.85) | |
| Example 12 | 40% GBL solution of P3 (25) | TEPIC-VL (8) | EXA-4850-150 (4) | WPI-116 (0.6) | GBL (5) | -0.01 |
| | | | | | UVS-2171 (0.4) | |
| | | | | | KBM-303 (0.85) | |
| Example 13 | 40% GBL solution of P3 (25) | TEPIC-VL (8) | EXA-4850-150 (4) | WPAG-370 (0.6) | GBL (5) | -0.01 |
| | | | | | UVS-2171 (0.4) | |
| | | | | | KBM-303 (0.85) | |
| Example 14 | 40% GBL solution of P3 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Example 15 | 40% GBL solution of P4 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Example 16 | 40% GBL solution of P5 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Example 17 | 40% GBL solution of P6 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Example 18 | 40% GBL solution of P7 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Example 19 | 40% GBL solution of P8 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Example 20 | 40% GBL solution of P9 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |

### [Table 2-3]

**[Table 2-3]**

| | components of photosensitive resin composition (content/g) | | | | | |
|---|---|---|---|---|---|---|
| | polymer compound (A) | cationic polymerizable compound (B) | | (C) cationic polymerization initiator | other components | log P value of component (B-1) |
| | | component (B-1) | component (B-2) | | | |
| Example 21 | 40% GBL solution of P10 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Example 22 | 40% GBL solution of P11 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Example 23 | 40% GBL solution of P3 (25) | TEPIC-VL (8) | YX-4000H (4) | (M-1) (0.6) | GBL (5) | -0.01 |
| | | | | | UVS-2171 (0.4) | |
| | | | | | KBM-303 (0.85) | |
| Example 24 | 40% GBL solution of P3 (25) | TEPIC-VL (8) | YL-983U (4) | (M-1) (0.6) | GBL (5) | -0.01 |
| | | | | | UVS-2171 (0.4) | |
| | | | | | KBM-303 (0.85) | |
| Example 25 | 40% GBL solution of P3 (25) | PETG (8) | EXA-4850-150 (4) | (M-1) (0.6) | GBL (5) | -1.93 |
| | | | | | UVS-2171 (0.4) | |
| | | | | | KBM-303 (0.85) | |
| Example 26 | 40% GBL solution of P3 (25) | TEPIC-VL (8) | EXA-4850-150 (4) | CPI-310B (0.6) | GBL (5) | -0.01 |
| | | | | | UVS-2171 (0.4) | |
| | | | | | KBM-303 (0.85) | |
| Example 27 | 40% GBL solution of P3 (25) | TEPIC-VL (8) | EXA-4850-150 (4) | CPI-410S (0.6) | GBL (5) | -0.01 |
| | | | | | UVS-2171 (0.4) | |
| | | | | | KBM-303 (0.85) | |
| Example 28 | 40% GBL solution of P3 (25) | tetramethyl biphenyl oxirane (12) | - | (M-1) (0.6) | GBL (5) | 5.26 |
| | | | | | UVS-2171 (0.4) | |
| | | | | | KBM-303 (0.85) | |
| Example 29 | 40% GBL solution of P3 (25) | tetramethyl biphenyl oxirane (8) | EXA-4850-150 (4) | (M-1) (0.6) | GBL (5) | 5.26 |
| | | | | | UVS-2171 (0.4) | |
| | | | | | KBM-303 (0.85) | |
| Example 30 | 40% GBL solution of P3 (25) | - | EXA-4816 (12) | (M-1) (0.6) | GBL (5) | - |
| | | | | | UVS-2171 (0.4) | |
| | | | | | KBM-303 (0.85) | |

### [Table 2-4]

**[Table 2-4]**

| | components of photosensitive resin comnosition (content/g) | | | | | |
|---|---|---|---|---|---|---|
| | polymer compound (A) | cationic polymerizable compound (B) | | (C) cationic polymerization initiator | other components | log P value of component (B-1) |
| | | component (B-1) | component (B-2) | | | |
| Comparative example 1 | 40% GBL solution of P12 (25) | TEPIC-VL (9) | - | WPI-116 (0.6) | GBL (5) | -0.01 |
| | | | | | UVS-2171 (0.4) | |
| | | | | | KBM-303 (0.85) | |
| Comparative example 2 | 40% GBL solution of P12 (25) | TEPIC-VL (16) | - | WPI-116 (0.6) | GBL (5) | -0.01 |
| | | | | | UVS-2171 (0.4) | |
| | | | | | KBM-303 (0.85) | |
| Comparative example 3 | 40% GBL solution of P12 (25) | TEPIC-VL (12) | - | WPI-116 (0.6) | GBL (5) | -0.01 |
| | | | | | UVS-2171 (0.4) | |
| | | | | | KBM-303 (0.85) | |
| Comparative example 4 | 40% GBL solution of P13 (25) | TEPIC-VL (8) | EXA-4850-150 (4) | (M-1) (0.6) | GBL (5) | -0.01 |
| | | | | | UVS-2171(0.4) | |
| | | | | | KBM-303(0.85) | |
| Comparative example 5 | 40% GBL solution of P14 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Comparative example 6 | 40% GBL solution of P15 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Comparative example 7 | 40% GBL solution of P16 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |
| Comparative example 8 | 40% GBL solution of P17 (25) | TEPIC-VL (8) | EXA-4850-150 (4) | (M-1) (0.6) | GBL (5) | -0.01 |
| | | | | | UVS-2171 (0.4) | |
| | | | | | KBM-303 (0.85) | |

Evaluation results obtained in Examples 1 to 30 and Comparative example 1 to 8 are shown in Table 3.

### [Table 3-1]

**[Table 3-1]**

| | evaluation results | | | | | | | | | | | | |
|---|---|---|---|---|---|---|---|---|---|---|---|---|---|
| | (1) transmittance (%) | (2) storage stability | | developer | (3) cationic curability | (4) pattern processability | (5) heat resistance | | (6) mechanical characteristics | | | | (7) copper corrosivity |
| | | viscosity rise rate (%) | rating | | | | glass transition temperature (°C) | rating | tensile elongation (%) | rating | tensile strength (MPa) | rating | |
| Example 1 | 82 | 13 | B | TMAH | D | D | 250°C | A | 15 | B | 80 | C | C |
| Example 2 | 82 | 2 | A | TMAH | D | C | 240°C | A | 15 | B | 80 | C | C |
| Example 3 | 98 | 2 | A | TMAH | C | B | 240°C | A | 17 | B | 80 | C | C |
| Example 4 | 98 | 1 | A | TMAH | B | B | 240°C | A | 15 | B | 80 | C | B |
| Example 5 | 98 | 3 | A | TMAH | A | A | 240°C | A | 14 | B | 85 | C | A |
| Example 6 | 98 | 2 | A | TMAH | A | A | 240°C | A | 17 | B | 85 | C | A |
| Example 7 | 98 | 2 | A | TMAH | A | A | 240°C | A | 15 | B | 85 | C | A |
| Example 8 | 98 | 4 | A | TMAH | A | A | 220°C | A | 15 | B | 80 | C | A |
| Example 9 | 98 | 3 | A | TMAH | A | A | 260°C | A | 16 | B | 85 | C | A |
| Example 10 | 99 | 2 | A | TMAH | A | A | 220°C | A | 15 | B | 83 | C | A |

### [Table 3-2]

**[Table 3-2]**

| | evaluation results | | | | | | | | | | | | |
|---|---|---|---|---|---|---|---|---|---|---|---|---|---|
| | (1) transmittance (%) | (2) storage stability | | developer | (3) cationic curability | (4) pattern processability | (5) heat resistance | | (6) mechanical characteristics | | | | (7) copper corrosivity |
| | | viscosity rise rate (%) | rating | | | | glass transition temperature (°C) | rating | tensile elongation (%) | rating | tensile strength (MPa) | rating | |
| Example 11 | 93 | 2 | A | TMAH | A | A | 280°C | A | 12 | B | 86 | C | A |
| Example 12 | 98 | 3 | A | TMAH | D | B | 220°C | A | 30 | A | 90 | B | C |
| Example 13 | 98 | 3 | A | TMAH | C | B | 220°C | A | 33 | A | 90 | B | B |
| Example 14 | 98 | 2 | A | TMAH | A | A | 230°C | A | 35 | A | 105 | A | A |
| Example 15 | 98 | 1 | A | TMAH | A | A | 230°C | A | 33 | A | 100 | A | A |
| Example 16 | 98 | 4 | A | TMAH | A | A | 220°C | A | 20 | B | 90 | B | A |
| Example 17 | 95 | 2 | A | TMAH | A | A | 220°C | A | 20 | B | 90 | B | A |
| Example 18 | 99 | 4 | A | TMAH | A | A | 230°C | A | 35 | A | 105 | A | A |
| Example 19 | 94 | 10 | B | TMAH | C | B | 220°C | A | 35 | A | 100 | A | B |
| Example 20 | 92 | 4 | A | CP | A | B | 230°C | A | 30 | A | 95 | B | A |

### [Table 3-3]

**[Table 3-3]**

| | evaluation results | | | | | | | | | | | | |
|---|---|---|---|---|---|---|---|---|---|---|---|---|---|
| | (1) transmittance (%) | (2) storage stability | | developer | (3) cationic curability | (4) pattern processability | (5) heat resistance | | (6) mechanical characteristics | | | | (7) copper corrosivity |
| | | viscosity rise rate (%) | rating | | | | glass transition temperature (°C) | rating | tensile elongation (%) | rating | tensile strength (MPa) | rating | |
| Example 21 | 90 | 4 | A | TMAH | D | B | 240°C | A | 30 | A | 100 | A | A |
| Example 22 | 95 | 9 | B | TMAH | A | A | 240°C | A | 35 | A | 100 | A | A |
| Example 23 | 98 | 2 | A | TMAH | A | A | 240°C | A | 30 | A | 90 | B | A |
| Example 24 | 98 | 3 | A | TMAH | A | A | 240°C | A | 35 | A | 100 | A | A |
| Example 25 | 98 | 2 | A | TMAH | A | A | 260°C | A | 25 | B | 90 | B | A |
| Example 26 | 98 | 3 | A | TMAH | A | A | 240°C | A | 30 | A | 90 | B | B |
| Example 27 | 98 | 3 | A | TMAH | A | A | 230°C | A | 33 | A | 95 | B | B |
| Example 28 | 98 | 2 | A | TMAH | A | C | 230°C | A | 16 | B | 83 | C | A |
| Example 29 | 96 | 3 | A | TMAH | A | C | 220°C | A | 31 | A | 100 | A | A |
| Example 30 | 95 | 4 | A | TMAH | B | C | 190°C | B | 40 | A | 112 | A | B |

### [Table 3-4]

**[Table 3-4]**

| | evaluation results | | | | | | | | | | | | |
|---|---|---|---|---|---|---|---|---|---|---|---|---|---|
| | (1) transmittance (%) | (2) storage stability | | developer | (3) cationic curability | (4) pattern processability | (5) heat resistance | | (6) mechanical characteristics | | | | (7) copper corrosivity |
| | | viscosity rise rate (%) | rating | | | | glass transition temperature (°C) | rating | tensile elongation (%) | rating | tensile strength (MPa) | rating | |
| Comparative example 1 | 86 | 40 | C | TMAH | E | E | 220°C | A | 17 | B | 85 | C | C |
| Comparative example 2 | 86 | 48 | C | TMAH | D | D | 260°C | A | 13 | B | 82 | C | C |
| Comparative example 3 | 85 | 40 | C | TMAH | D | C | 250°C | A | 15 | B | 80 | C | C |
| Comparative example 4 | 98 | 42 | C | TMAH | A | A | 260°C | A | 35 | A | 105 | A | A |
| Comparative example 5 | 98 | 15 | B | TMAH | A | A | 250°C | A | 35 | A | 105 | A | A |
| Comparative example 6 | 98 | 1 | A | TMAH | E | E | 230°C | A | 9 | C | 70 | C | A |
| Comparative example 7 | 97 | 2 | A | TMAH | E | E | 250°C | A | 33 | A | 90 | B | A |
| Comparative example 8 | 99 | 15 | B | TMAH | C | B | 230°C | A | 8 | C | 70 | C | A |

### [Example 31] to [Example 34]

Negative type photosensitive resin compositions were prepared in the same way as in Example 1 using the components (A) to (D) in combination with other components as listed in Table 4, and yellowing of the cured films, contents of F⁻, Cl⁻; Br-, and I⁻, resistance to ion migration, melt viscosity at 40°C, and stress in the cured films of the negative type photosensitive resin compositions were evaluated according to the evaluation methods described in the sections (8) to (12) below.

### [Comparative examples 9] to [Comparative example 13]

Negative type photosensitive resin compositions were prepared in the same way as in Example 1 using the components (A) to (D) in combination with other components as listed in Table 4, and yellowing of the cured films, contents of F⁻, Cl⁻; Br-, and I⁻, resistance to ion migration, melt viscosity at 40°C, and stress in the cured films of the negative type photosensitive resin compositions were evaluated according to the evaluation methods described in the sections (8) to (12) below.

### [Table 4]

**[Table 4]**

| | components of photosensitive resin comnosition (content/g) | | | | | |
|---|---|---|---|---|---|---|
| | polymer compound (A) | cationic polymerizable compound (B) | | (C) cationic polymerization initiator | other components | log P value of component (B-1) |
| | | component (B-1) | component (B-2) | | | |
| Example 31 | same as in Example 7 | | | | | |
| Example 32 | same as in Example 10 | | | | | |
| Example 33 | same as in Example 11 | | | | | |
| Example 34 | same as in Example 30 | | | | | |
| Comparative example 9 | 40% GBL solution of P13 (25) | TEPIC-VL (12) | - | CPI-310B (0.6) | GBL (5) | -0.01 |
| | | | | | UVS-2171 (0.4) | |
| | | | | | KBM-303 (0.85) | |
| Comparative example 10 | 40% GBL solution of P13 (25) | TEPIC-VL (12) | - | CPI-410S (0.6) | GBL (5) | -0.01 |
| | | | | | UVS-2171 (0.4) | |
| | | | | | KBM-303 (0.85) | |
| Comparative example 11 | 40% GBL solution of P13 (25) | - | EXA-4816 (12) | (M-1) (0.6) | GBL (5) | - |
| | | | | | UVS-2171 (0.4) | |
| | | | | | KBM-303 (0.85) | |
| Comparative example 12 | 40% GBL solution of 1007 (25) | TEPIC-VL (12) | - | (M-1) (0.6) | GBL (5) | -0.01 |
| | | | | | UVS-2171 (0.4) | |
| | | | | | KBM-303 (0.85) | |
| Comparative example 13 | 40% GBL solution of P18 (25) | TEPIC-VL (12) | - | (M-1) (0.6) | GBL (5) | -0.01 |
| | | | | | UVS-2171 (0.4) | |
| | | | | | KBM-303 (0.85) | |

Evaluation results obtained in Examples 31 to 34 and Comparative example 9 to 13 are shown in Table 5.

### [Table 5]

**[Table 5]**

| | evaluation results | | | | | |
|---|---|---|---|---|---|---|
| | (8) yellowing of cured film | (9) F⁻, Cl⁻, Br, I⁻ content (ppm by mass) | (10) resistance to ion migration | (11) melt viscosity at 40°C (Pa·s) | (12) stress in cured film (MPa) | T₂/T₁ |
| Example 31 | A | 36 | B | 1.8×10⁶ | 13 | 0.98 |
| Example 32 | A | 4 | A | 1.4×10⁶ | 11 | 0.98 |
| Example 33 | A | 6 | A | 3.0×10⁶ | 14 | 0.98 |
| Example 34 | A | 320 | C | 1.8×10⁶ | 12 | 0.98 |
| Comparative example 9 | B | 45 | B | 1.8×10⁶ | 13 | 0.98 |
| Comparative example 10 | B | 45 | B | 1.8×10⁶ | 11 | 0.98 |
| Comparative example 11 | A | 301 | C | 1.0×10⁶ | 10 | 0.98 |
| Comparative example 12 | A | 40 | B | 0.2×10⁶ | 10 | 0.99 |
| Comparative example 13 | A | 36 | B | 1.5×10⁶ | 25 | 0.85 |

## Claims

1. A negative type photosensitive resin composition comprising a polymer compound (A), a cationic polymerizable compound (B), and a cationic polymerization initiator (C) wherein:
the component (A) contains at least one compound selected from the group consisting of polyamide, polyimide, polybenzoxazole, precursors thereof, and copolymers thereof; and
both the relations 0.6A ≤ B + 0.5C ≤ 0.98A and 0.05(B + C) ≤ C ≤ 0.25(B + C) are satisfied where A (moles), B (moles), and C (moles) represent the quantities of all carboxylic acid residues, all diamine residues, and all monoamine residues, respectively, contained in the component (A).

2. A negative type photosensitive resin composition as set forth in claim 1 wherein the monoamine residues have structures as represented by the formula (3): 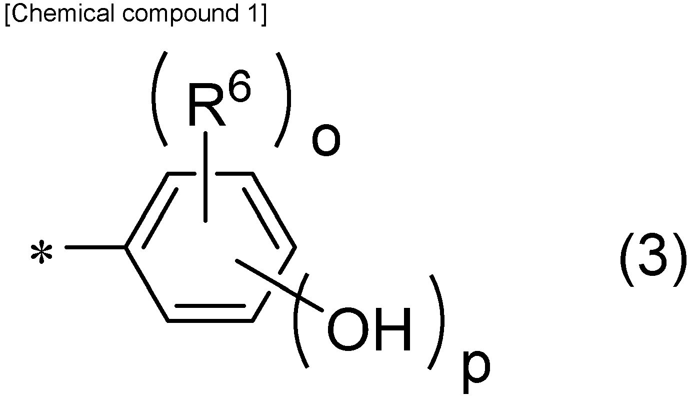 wherein in the formula (3), R⁶ is a monovalent organic group having 1 to 6 carbon atoms; o denotes 0 or 1; p denotes 0 or 1; and * denotes a bonding point.

3. A negative type photosensitive resin composition as set forth in either claim 1 or 2 wherein the light transmittance at a wavelength of 365 nm per µm film thickness of the component (A) is 90% or more.

4. A negative type photosensitive resin composition as set forth in any one of claims 1 to 3 wherein the component (B) contains a polyfunctional epoxy compound (B-1) with an epoxy equivalent weight of 80 g/eq or more and less than 160 g/eq and wherein the component (B-1) has an octanol-water distribution coefficient (log P value) of -2 or more and less than 5.

5. A negative type photosensitive resin composition as set forth in any one of claims 1 to 4 wherein the component (B) accounts for 100 parts by mass or more and 150 parts by mass or less relative to 100 parts by mass of the component (A).

6. A negative type photosensitive resin composition as set forth in any one of claims 1 to 5 wherein the component (B) contains a polyfunctional epoxy compound (B-1) with an epoxy equivalent weight of 80 g/eq or more and less than 160 g/eq and a polyfunctional epoxy compound (B-2) with an epoxy equivalent weight of 160 g/eq or more and less than 500 g/eq and wherein the component (B-1) accounts for 40 to 99 mass% and the component (B-2) accounts for 1 to 60 mass% in the component (B).

7. A negative type photosensitive resin composition as set forth in any one of claims 1 to 6 wherein the component (C) contains a sulfonium salt.

8. A negative type photosensitive resin composition as set forth in claim 7 wherein the sulfonium salt contains, as a counter anion, at least one selected from the group consisting of borate ion, phosphate ion, and gallate ion.

9. A negative type photosensitive resin composition as set forth in claim 7 wherein the sulfonium salt contains the gallate ion as a counter anion.

10. A negative type photosensitive resin composition as set forth in any one of claims 1 to 9 wherein the content of F⁻, Cl⁻, Br, and I⁻ is less than 100 ppm by mass.

11. A negative type photosensitive resin composition film comprising a support body and a negative type photosensitive resin composition coating film formed thereon from a negative type photosensitive resin composition as set forth in any one of claims 1 to 10 wherein the negative type photosensitive resin composition coating film has a melt viscosity at 40°C of 0.5 × 10⁶ MPa·s or more and 1.0 × 10⁷ MPa·s or less.

12. A cured product produced by curing a negative type photosensitive resin composition as set forth in any one of claims 1 to 10 or by curing a negative type photosensitive resin composition coating film as set forth in claim 11.

13. A cured product as set forth in claim 12 wherein the negative type photosensitive resin composition coating film satisfies the relation T₂ / T₁ ≥ 0.98 where T₁ is the coating film thickness and T₂ is the coating film thickness after curing at 200°C for 1 hour.

14. A production method for a cured product comprising a step for spreading a negative type photosensitive resin composition as set forth in any one of claims 1 to 10 over a substrate followed by drying it to form a negative type photosensitive resin composition coating film on the substrate, a step for applying light to the photosensitive resin composition coating film, a step for developing the negative type photosensitive resin composition coating film to remove the unexposed portions using an alkaline aqueous solution, and a step for heat-treating the developed photosensitive resin film to form a cured product.

15. A hollow structure comprising a support material containing a cured product as set forth in claim 12.

16. An electronic component comprising a cured product as set forth in claim 12.
